# EUROPEAN PATENT APPLICATION

(11) **EP 4 404 274 A1**
(43) Date of publication of application: **24.07.2024**
(21) Application number: 22959263.9
(22) Date of filing: 23.09.2022
(51) Int. Cl.: H01L 29/78

(54) **SEMICONDUCTOR DEVICE AND PREPARATION METHOD THEREFOR, POWER CONVERSION CIRCUIT AND VEHICLE**

(71) Applicant: Huawei Digital Power Technologies Co., Ltd., Shenzhen, Guangdong 518043 (CN)
(72) Inventor: HAMADA, Kimimori, Shenzhen, Guangdong 518043 (CN); HU, Fei, Shenzhen, Guangdong 518043 (CN)
(74) Representative: Isarpatent
(86) International application number: PCT/CN2022/121115
(87) International publication number: WO 2024/060261

(57) **Abstract**

This application discloses a semiconductor device, a manufacturing method thereof, a power conversion circuit, and a vehicle. The semiconductor device includes an N-type semiconductor substrate, an epitaxial layer, a trench structure, a gate, an interlayer dielectric layer, a source, and a drain. The trench structure is disposed at the epitaxial layer. The trench structure includes a plurality of first trenches and one second trench. The plurality of first trenches extend in a first direction and are arranged at intervals in a second direction. The second trench extends in the second direction. The second trench and each of the plurality of first trenches are disposed in a cross manner and communicate with each other. The gate is filled in the trench structure, and is spaced apart by a gate dielectric layer. The interlayer dielectric layer covers the gate, and has a contact hole that extends in the second direction. The source is disposed at the interlayer dielectric layer, and is in contact, through the contact hole, with the epitaxial layer. The drain is disposed on a side that is of the semiconductor substrate and that is away from the epitaxial layer. In this way, total on-resistance of the device is reduced.

## Description

### TECHNICAL FIELD

This application relates to the field of semiconductor technologies, and in particular, to a semiconductor device, a manufacturing method thereof, a power conversion circuit, and a vehicle.

### BACKGROUND

Compared with a silicon (silicon, Si) material, a silicon carbide (silicon carbide, SiC) material has advantages such as a wide band gap, a high critical breakdown electric field, high thermal conductivity, and a high electron saturation drift velocity. Compared with an insulated gate bipolar transistor (insulated gate bipolar transistor, IGBT) made of the Si material, a metal-oxide-semiconductor field-effect transistor (metal-oxide-semiconductor field-effect transistor, MOSFET) made of the SiC material has properties such as a high breakdown voltage and a low conduction voltage drop. In addition, a monopole conductive property enables the SiC MOSFET to have a faster switching speed, a lower conduction loss, and a lower switching loss than the Si IGBT. Therefore, the SiC MOSFET has replaced the Si IGBT in some application scenarios such as fields of an on-board micro controller unit (micro controller unit, MCU) and an on-board battery charger (on-board battery charger, OBC).

Compared with a device of a common planar gate structure, in a SiC MOSFET device of a trench gate structure, a gate is built into a SiC body, so that a conductive channel of the device is changed from a planar direction to a vertical direction. Therefore, a cell size of the device is clearly reduced, and density of the conductive channel of the device is greatly improved, so that on-resistance of a chip can be significantly reduced, and a through-current capability can be improved. The trench gate structure has become a mainstream technical direction of future devices.

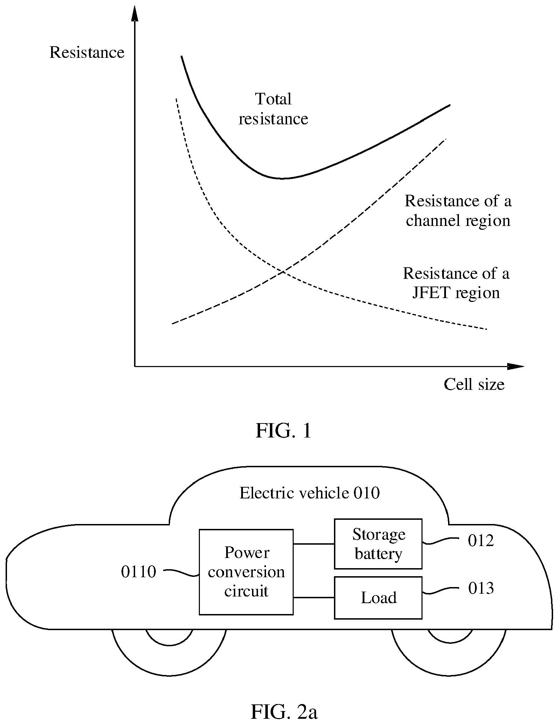

However, in the SiC MOSFET device of the trench gate structure, there is an obvious contradiction relationship between resistance of a channel region and resistance of a junction field effect transistor (junction field effect transistor, JFET) region. Refer to FIG. 1. A horizontal coordinate represents a cell size, and a vertical coordinate represents resistance. It may be learned from FIG. 1 that a spacing between trench gate structures in a SiC MOSFET device is reduced, so that the cell size of the SiC MOSFET device can be reduced, density of a conductive channel can be increased, and resistance of a channel region can be reduced. However, a through-current width of the JFET region is also reduced accordingly, leading to an increase in the resistance of the JFET region. Consequently, total on-resistance of the entire SiC MOSFET device is increased instead, device performance is reduced, and a chip loss is increased.

### SUMMARY

This application provides a semiconductor device, a manufacturing method thereof, a power conversion circuit, and a vehicle, to reduce total on-resistance of the device, improve device performance, and reduce a device loss.

According to a first aspect, this application provides a semiconductor device, and the semiconductor device includes an N-type semiconductor substrate, an epitaxial layer, a trench structure, a gate, an interlayer dielectric layer, a source, and a drain. The trench structure is disposed at the epitaxial layer. The trench structure may specifically include a plurality of first trenches and one second trench. All of the plurality of first trenches extend in a first direction parallel to a plane on which the semiconductor substrate is located, and are arranged at intervals in a second direction parallel to the plane on which the semiconductor substrate is located. The second trench extends in the second direction, and the second trench and each of the plurality of first trenches are disposed in a cross manner and communicate with each other. A main function of the second trench is to connect the first trenches. The tightly arranged trench structure may be formed by disposing the first trench and the second trench at the epitaxial layer. The gate is filled and disposed in the trench structure, and is spaced apart by a gate dielectric layer. Parts that are of the gate and that are disposed in the plurality of first trenches extend in the first direction, and parts that are of the gate and that are disposed in the second trench extend in the second direction, and are configured to connect the parts that are of the gate and that extend in the first direction. For example, the epitaxial layer may include a first N-type semiconductor region, a second N-type semiconductor region, a first P-type semiconductor region, and a source region that are sequentially disposed on the semiconductor substrate. In a third direction perpendicular to the plane on which the semiconductor substrate is located, the trench structure may extend to the first N-type semiconductor region. The first direction, the second direction, and the third direction are set in a cross manner. For example, the first direction, the second direction, and the third direction are set to be perpendicular to each other. Existence of the trench structure enables the gate to be built inside the epitaxial layer of a material. The gate and the first P-type semiconductor region form a trench gate structure of a SiC MOSFET device by using the gate dielectric layer, so that the semiconductor device provided in this embodiment of this application is a SiC MOSFET of the trench gate structure. The interlayer dielectric layer is disposed on the gate and covers the gate. The source is disposed at the interlayer dielectric layer. In other words, the source covers the entire interlayer dielectric layer. The drain is disposed on a side that is of the semiconductor substrate and that is away from the epitaxial layer. In other words, the drain covers a side that is of the semiconductor substrate and that is not disposed with an epitaxial layer. In actual application, if a signal needs to be transmitted between the source and the drain, a contact hole extending in the second direction may be disposed at the interlayer dielectric layer. To avoid contact between the source and the gate, a projection of the contact hole in the third direction may not overlap the gate, and the contact hole does not overlap the gate. In addition, the contact hole may expose a partial region of the epitaxial layer. For example, the contact hole may expose a partial region of the source region, so that the source is in contact with the source region through the contact hole. When the gate controls a channel to be conducted, a signal may be transmitted between the source and the drain. Parts of two side walls that are of each first trench in the trench structure and that are disposed opposite to each other in the second direction are channels.

According to the semiconductor device provided in this embodiment of this application, because an extension direction of the contact hole disposed at the interlayer dielectric layer is the second direction, and an extension direction of each first trench in the trench structure is the first direction, the extension direction of the contact hole is perpendicular to the extension direction of each first trench. In other words, the contact hole is disposed in a direction perpendicular to a first channel. Therefore, in comparison with a manner, in a conventional technology, in which the trench structure is disposed in parallel to the contact hole, according to the semiconductor device provided in this embodiment of this application, a limitation imposed by the contact hole on a trench spacing between adjacent first trenches in the second direction is reduced, so that the trench structure can be manufactured more tightly. In other words, the gate is also tighter. Therefore, an array density of the trench structure of the semiconductor device provided in this embodiment of this application may be far higher than an array density of a trench structure of a device structure in a conventional technology. Therefore, a channel density of the SiC MOSFET is increased, total on-resistance of the device is clearly reduced, device performance is improved, and a device loss is reduced.

In this application, the semiconductor substrate may be a SiC single crystal substrate doped with a pentavalent element. A SiC material that is generated through epitaxial growth and that is doped with a corresponding impurity may be used for the epitaxial layer. For example, the first N-type semiconductor region may be a partial region of the epitaxial layer formed through epitaxial growth, and the second N-type semiconductor region and the source region may be formed by doping the epitaxial layer by using an ion implantation process. In addition, the N-type semiconductor region is mainly doped with an N-type impurity, for example, nitrogen (N), phosphorus (P), or arsenic (As). For example, a doping concentration of the semiconductor substrate is usually greater than a doping concentration of the second N-type semiconductor region. The doping concentration of the second N-type semiconductor region is usually greater than a doping concentration of the first N-type semiconductor region. A doping concentration of the source region is usually greater than the doping concentration of the second N-type semiconductor region.

In this application, the first P-type semiconductor region may be formed by doping the epitaxial layer by using the ion implantation process. In addition, the P-type semiconductor region is mainly doped with a P-type impurity, for example, boron (B), aluminum (Al), or gallium (Ga).

A material of a gate 11 is not limited in this application. For example, the material of the gate may be a polycrystalline silicon material, or may be another material having a good conductive property, for example, metal (for example, W, Al, Ti, Cu, Mo, or Pt).

A material for forming the interlayer dielectric layer is not limited in this application. For example, the material for forming the interlayer dielectric layer may be a dielectric material. The dielectric material includes but is not limited to silicon dioxide (SiO₂), silicon nitride (SiNO), silicon carbon oxide (SiCO), silicon nitride (SiNx), and the like.

A material for forming the source and the drain is not limited in this application. For example, the material for forming the source and the drain may be a metal material. For example, the metal material may include W, Al, Ti, Cu, Mo, Pt, or the like.

In some possible implementations of this application, there may be a plurality of trench structures and a plurality of contact holes in the semiconductor device. Specifically, a trench structure may be disposed between two adjacent contact holes, so that signals can evenly flow. When there are a plurality of trench structures, structural parameters of the trench structures may be the same, to ensure that the trench structures are evenly distributed. For example, quantities of first trenches may be the same, trench spacings between the first trenches may be the same, trench lengths of the first trenches may be the same, and lengths of the second trenches may be the same. In actual application, the quantity of first trenches in the trench structure may be determined based on an actual application requirement. This is not limited in this application.

In some possible implementations of this application, alternatively, quantities of first trenches in some trench structures may be the same, and quantities of first trenches in the other trench structures may be different. Alternatively, quantities of first trenches in different trench structures may be different. In actual application, the quantity of first trenches in the trench structure may be determined based on an actual application requirement. This is not limited in this application.

In some possible implementations of this application, in the second direction, two first trenches that are located at edges of the trench structure may be respectively defined as a first edge trench and a second edge trench, and the contact hole extends, in the second direction, from a side that is of the first edge trench and that is away from the second edge trench to a side that is of the second edge trench and that is away from the first edge trench. In other words, the contact hole is a continuous opening, and first trenches in different trench structures do not communicate with each other.

The semiconductor device provided in this embodiment of this application is a SiC MOSFET device of the trench gate structure. In the SiC MOSFET device of the trench gate structure, the gate dielectric layer at a bottom and a corner of the trench structure of the SiC MOSFET device bears extremely high electric field strength when the device works, is a weak point for electric field breakdown, and easily causes a reliability failure when the device works for a long period. Therefore, how to effectively shield the gate dielectric layer from a high electric field stress becomes a key to a high robustness/reliability design of the device.

In some possible implementations of this application, a second P-type semiconductor region may be further disposed at the epitaxial layer. The second P-type semiconductor region is disposed below the trench structure, and the second P-type semiconductor region may be connected to the source. In some possible implementations of this application, the second P-type semiconductor region may be disposed in direct contact with the bottom of the trench structure. When the SiC MOSFET device works, a voltage is loaded on the source. Because the second P-type semiconductor region is connected to the source, the voltage loaded on the source is input to the second P-type semiconductor region, so that the second P-type semiconductor region also has a corresponding voltage, an electric field of the gate dielectric layer at the bottom of the trench structure can be effectively shielded, and working robustness of the device is improved.

For example, when the SiC MOSFET provided in this embodiment of this application is used in an electronic device, the source of the SiC MOSFET may be grounded, and the drain of the SiC MOSFET may be connected to another component. In this case, the voltage of the source of the SiC MOSFET is a ground voltage (0 V). Because the second P-type semiconductor region is connected to the source, the voltage of the second P-type semiconductor region is also a ground voltage, so that the electric field of the gate dielectric layer at the bottom of the trench structure can be effectively shielded, and working robustness of the device is improved.

For example, when the SiC MOSFET provided in this embodiment of this application is used in an electronic device, the source of the SiC MOSFET may alternatively be connected to another component, and the drain of the SiC MOSFET is also connected to another component. In this case, the voltage of the source of the SiC MOSFET is a voltage of a signal input by the another component. Because the second P-type semiconductor region is connected to the source, the voltage of the second P-type semiconductor region is also the voltage of the input signal, so that the electric field of the gate dielectric layer at the bottom of the trench structure can be effectively shielded, and working robustness of the device is improved.

A thickness of the second P-type semiconductor region in the third direction is not limited in this application. In some embodiments of this application, a thickness range of the second P-type semiconductor region in the third direction may be less than 1 µm. For example, the thickness range of the second P-type semiconductor region in the third direction may be 0.3 µm to 0.8 µm.

In some possible implementations of this application, the epitaxial layer may further include a third P-type semiconductor region and a fourth P-type semiconductor region. The third P-type semiconductor region is disposed on at least one side wall of the trench structure, and the fourth P-type semiconductor region and the source region are disposed at a same layer. The third P-type semiconductor region is in contact with the second P-type semiconductor region. The fourth P-type semiconductor region and the third P-type semiconductor region are disposed in a one-to-one correspondence and are in contact with each other. The voltage may be input to the second P-type semiconductor region sequentially through the fourth P-type semiconductor region and the third P-type semiconductor region, so that the electric field of the gate dielectric layer at the bottom of the trench structure can be effectively shielded, and working robustness of the device is improved.

Specifically, the first P-type semiconductor region, the second P-type semiconductor region, the third P-type semiconductor region, and the fourth P-type semiconductor region may be formed by doping the epitaxial layer by using the ion implantation process. In addition, the P-type semiconductor region is mainly doped with a P-type impurity, for example, boron (B), aluminum (Al), or gallium (Ga).

For example, doping concentrations of the second P-type semiconductor region, the third P-type semiconductor region, and the fourth P-type semiconductor region are greater than a doping concentration of the first P-type semiconductor region. Optionally, the doping concentrations of the second P-type semiconductor region, the third P-type semiconductor region, and the fourth P-type semiconductor region may be the same or similar. Certainly, at least two of the doping concentrations of the second P-type semiconductor region, the third P-type semiconductor region, and the fourth P-type semiconductor region may alternatively be different. It should be noted that the doping concentrations of the second P-type semiconductor region, the third P-type semiconductor region, and the fourth P-type semiconductor region may be determined based on a requirement of an actual application environment. This is not limited herein.

In some possible implementations of this application, in the first direction, each of the plurality of first trenches may have a first side wall and a second side wall that are disposed opposite to each other, and the third P-type semiconductor regions may be disposed on a first side wall and a second side wall of at least one of the plurality of first trenches. In other words, the first side wall and the second side wall of at least one first trench each are disposed with the third P-type semiconductor region. In addition, each of the third P-type semiconductor regions is in contact with the second P-type semiconductor region, so that each of the third P-type semiconductor regions is connected to the second P-type semiconductor region to perform signal transmission, and a voltage of each of the third P-type semiconductor regions is the same as the voltage of the second P-type semiconductor region. Correspondingly, the fourth P-type semiconductor region is in a one-to-one correspondence with and is disposed in contact with the third P-type semiconductor region, and the fourth P-type semiconductor region is in contact with a corresponding source through the contact hole. One fourth P-type semiconductor region is disposed in correspondence with the third P-type semiconductor region disposed on the first side wall, and the fourth P-type semiconductor region is disposed on a side that is of the third P-type semiconductor region and that is away from the first side wall of the first trench. In addition, one fourth P-type semiconductor region is disposed in correspondence with the third P-type semiconductor region disposed on the second side wall, and the fourth P-type semiconductor region is disposed on a side that is of the third P-type semiconductor region and that is away from the second side wall of the first trench. The source is connected to the second P-type semiconductor region sequentially through the fourth P-type semiconductor region and the third P-type semiconductor region that are disposed in correspondence with each other, so that the voltage loaded on the source is input to the second P-type semiconductor region sequentially through the fourth P-type semiconductor region and the third P-type semiconductor region, the second P-type semiconductor region has the voltage, the electric field of the gate dielectric layer at the bottom of the trench structure can be effectively shielded, and working robustness of the device is improved.

In some possible implementations of this application, a plurality of third P-type semiconductor regions may be disposed. The first side wall of each first trench is disposed with one of the plurality of third P-type semiconductor regions, and the second side wall of each first trench is disposed with one of the plurality of third P-type semiconductor regions. In other words, the first side wall and the second side wall of each first trench each are disposed with the third P-type semiconductor region. In addition, each of the third P-type semiconductor regions is in contact with the second P-type semiconductor region, so that each of the third P-type semiconductor regions is connected to the second P-type semiconductor region to perform signal transmission, and the voltage of each of the third P-type semiconductor regions is the same as the voltage of the second P-type semiconductor region. Correspondingly, a plurality of fourth P-type semiconductor regions may be disposed, and the plurality of fourth P-type semiconductor regions are disposed in a one-to-one correspondence and in contact with the plurality of third P-type semiconductor regions. One of the plurality of fourth P-type semiconductor regions is disposed in correspondence with the third P-type semiconductor region disposed on the first side wall, and the fourth P-type semiconductor region is disposed on the side that is of the third P-type semiconductor region and that is away from the first side wall of the first trench. In addition, one of the plurality of fourth P-type semiconductor regions is disposed in correspondence with the third P-type semiconductor region disposed on the second side wall, and the fourth P-type semiconductor region is disposed on the side that is of the third P-type semiconductor region and that is away from the second side wall of the first trench. The source is connected to the second P-type semiconductor region sequentially through the fourth P-type semiconductor region and the third P-type semiconductor region that are disposed in correspondence with each other, so that the voltage loaded on the source is input to the second P-type semiconductor region sequentially through the fourth P-type semiconductor region and the third P-type semiconductor region, the second P-type semiconductor region has the voltage, the electric field of the gate dielectric layer at the bottom of the trench structure can be effectively shielded, and working robustness of the device is improved.

In some possible implementations of this application, a plurality of source regions may also be disposed. A plurality of source regions and a plurality of fourth P-type semiconductor regions that are located at a same end of the trench structure are alternately disposed. For example, a plurality of source regions and a plurality of fourth P-type semiconductor regions that are located on first side walls of a plurality of first trenches in a same trench structure are alternately disposed. In addition, a plurality of source regions and a plurality of fourth P-type semiconductor regions that are located on second side walls of a plurality of first trenches in a same trench structure are alternately disposed.

Specifically, a width of the fourth P-type semiconductor region in the second direction is not limited in this application. For example, the width of the fourth P-type semiconductor region in the second direction may be the same as or similar to a width of the first trench. Correspondingly, a width of the source region in the second direction is the same as or similar to the trench spacing between two adjacent first trenches. Certainly, the width of the fourth P-type semiconductor region in the second direction may alternatively be different from the width of the first trench. This is not limited herein.

In some possible implementations of this application, a projection of the second P-type semiconductor region in the third direction may cover the trench structure and the third P-type semiconductor region. In other words, an orthographic projection of the second P-type semiconductor region on the semiconductor substrate not only covers an orthographic projection of the trench structure on the semiconductor substrate, but also covers orthographic projections of all the third P-type semiconductor regions on the semiconductor substrate.

In some possible implementations of this application, the second P-type semiconductor region may be a planar region extending in the second direction. In addition, a shape of the second P-type semiconductor region is not limited in this application. For example, the shape of the second P-type semiconductor region may be set to a rectangle.

In some possible implementations of this application, the projection of the second P-type semiconductor region in the third direction may further cover a gap between two adjacent first trenches. For example, the projection of the second P-type semiconductor region in the third direction may further cover a gap between two adjacent first trenches in the second direction. In other words, the orthographic projection of the second P-type semiconductor region on the semiconductor substrate further covers an orthographic projection, on the semiconductor substrate, of the gap between two adjacent first trenches in the second direction.

In some possible implementations of this application, usually, one second P-type semiconductor region is disposed in correspondence with one trench structure. In other words, if one trench structure is disposed, one second P-type semiconductor region that is a planar region is correspondingly disposed. If two trench structures are disposed, two second P-type semiconductor regions that are planar regions are correspondingly disposed. In addition, there is a gap between the two second P-type semiconductor regions. If a plurality of trench structures are disposed, a plurality of second P-type semiconductor regions that are planar regions are correspondingly disposed. In addition, there is a gap between every two adjacent second P-type semiconductor regions.

Specifically, in the second direction, there is a trench spacing between two adjacent first trenches. A specific value of the trench spacing is not limited in this application. For example, the trench spacing may be less than 1 µm. Optionally, a range of the trench spacing is 50 nm to 0.5 µm. It should be noted that, when the trench spacing is less than 100 nm, the semiconductor device provided in this application forms a fin field effect transistor (Fin Field-Effect Transistor, Fin FET) effect, so that channel carrier mobility can be significantly improved, and the total on-resistance of the device can be further reduced.

Specifically, in the first direction, the first trench has a trench length. The trench length is not limited in this application. For example, the trench length may be greater than 5 µm.

Specifically, in the second direction, the first trench has a trench width. The trench width is not limited in this application. For example, the trench width may be less than 1 µm.

Specifically, in the first direction, the contact hole has a contact width, so that the trench spacing is not greater than the contact width. Certainly, the trench spacing may alternatively be greater than the contact width. In actual application, the trench spacing and the contact width may be determined based on an actual application environment requirement. This is not limited herein.

In the semiconductor device provided in this embodiment of this application, the first P-type semiconductor regions on two side walls that are of the first trench in the trench structure and that are in the second direction form channel regions of the SiC MOSFET. Therefore, the trench width is increased or the trench spacing is reduced, so that a density of a conductive channel of the SiC MOSFET device can be increased, and the total on-resistance of the SiC MOSFET device can be reduced.

In some possible implementations of this application, the semiconductor device may include an N-type semiconductor substrate, an epitaxial layer, a trench structure, a gate, an interlayer dielectric layer, a source, and a drain. In addition, the epitaxial layer may include a first N-type semiconductor region, a second N-type semiconductor region, a first P-type semiconductor region, a source region, a second P-type semiconductor region, a third P-type semiconductor region, and a fourth P-type semiconductor region. This embodiment is a variant of the implementations in the foregoing embodiment. The following describes only differences between this embodiment and the foregoing embodiment, and the same parts are not described herein again.

In this embodiment, there is a spacing region between the second P-type semiconductor region and a bottom of the trench structure. In other words, the second P-type semiconductor region at the bottom of the trench structure is not directly in contact with the bottom of the trench structure, but is connected to the bottom of the trench structure through the spacing region. For example, the spacing region may be an N-type semiconductor region, and a doping concentration of the spacing region is the same as or similar to a doping concentration of the first N-type semiconductor region. Optionally, the spacing region may be a part of the first N-type semiconductor region.

In this embodiment of this application, the spacing region may be a flow path of a conduction current of a SiC MOSFET device, so that an area of a through-current region of the SiC MOSFET device can be increased, and total on-resistance of the SiC MOSFET device can be further reduced.

In some possible implementations of this application, the semiconductor device may specifically include an N-type semiconductor substrate, an epitaxial layer, a trench structure, a gate, an interlayer dielectric layer, a source, and a drain. In addition, the epitaxial layer may include a first N-type semiconductor region, a second N-type semiconductor region, a first P-type semiconductor region, a source region, a second P-type semiconductor region, third P-type semiconductor regions, and fourth P-type semiconductor regions. This embodiment is a variant of the implementations in the foregoing embodiment. The following describes only differences between this embodiment and the foregoing embodiment, and the same parts are not described herein again.

In this embodiment, a plurality of third P-type semiconductor regions are disposed. A first side wall of each first trench is disposed with one of the plurality of third P-type semiconductor regions, and a second side wall of each first trench is not disposed with a third P-type semiconductor region. In other words, only the first side wall of each first trench is disposed with the third P-type semiconductor region. In addition, each of the third P-type semiconductor regions is in contact with the second P-type semiconductor region, so that each of the third P-type semiconductor regions is connected to the second P-type semiconductor region to perform signal transmission, and a voltage of each of the third P-type semiconductor regions is the same as a voltage of the second P-type semiconductor region.

Correspondingly, a plurality of fourth P-type semiconductor regions are also disposed, and the plurality of fourth P-type semiconductor regions are disposed in a one-to-one correspondence and in contact with the plurality of third P-type semiconductor regions. One of the plurality of fourth P-type semiconductor regions is disposed in correspondence with the third P-type semiconductor region disposed on the first side wall, and the fourth P-type semiconductor region is disposed on a side that is of the third P-type semiconductor region and that is away from the first side wall of the first trench. The source is connected to the second P-type semiconductor region sequentially through the fourth P-type semiconductor region and the third P-type semiconductor region that are disposed in correspondence with each other, so that a voltage loaded on the source is input to the second P-type semiconductor region sequentially through the fourth P-type semiconductor region and the third P-type semiconductor region, the second P-type semiconductor region has a voltage, an electric field of a gate dielectric layer at a bottom of the trench structure can be effectively shielded, and working robustness of the device is improved.

In this embodiment, the epitaxial layer may further include a fifth P-type semiconductor region. The fifth P-type semiconductor region and the source region are disposed at a same layer. The fifth P-type semiconductor region is disposed on a side that is of the second side wall of the first trench and that is away from the first side wall, and the fifth P-type semiconductor region is in contact with the source through a contact hole.

In this embodiment, a plurality of fifth P-type semiconductor regions may be disposed, and the plurality of fifth P-type semiconductor regions are disposed in a one-to-one correspondence with the second side walls of all the first trenches. In addition, a plurality of source regions and the plurality of fifth P-type semiconductor regions that are located on second side walls of the first trenches are alternately disposed.

Optionally, the fifth P-type semiconductor region may be formed by doping the epitaxial layer by using an ion implantation process. In addition, the fifth P-type semiconductor region is mainly doped with a P-type impurity, for example, boron (B), aluminum (Al), or gallium (Ga). For example, a doping concentration of the fifth P-type semiconductor region may be the same as or similar to a doping concentration of the fourth P-type semiconductor region.

In this embodiment of this application, the first side wall of the first trench is disposed with the third P-type semiconductor region, and no channel is formed.

In some possible implementations of this application, the semiconductor device may specifically include an N-type semiconductor substrate, an epitaxial layer, a trench structure, a gate, an interlayer dielectric layer, a source, and a drain. In addition, the epitaxial layer may include a first N-type semiconductor region, a second N-type semiconductor region, a first P-type semiconductor region, a source region, a second P-type semiconductor region, third P-type semiconductor regions, and fourth P-type semiconductor regions. This embodiment is a variant of the implementations in the foregoing embodiment. The following describes only differences between this embodiment and the foregoing embodiment, and the same parts are not described herein again.

In this embodiment, a plurality of third P-type semiconductor regions are disposed. A first side wall of each first trench is disposed with one of the plurality of third P-type semiconductor regions, and a second side wall of each first trench is not disposed with a third P-type semiconductor region. In other words, only the first side wall of each first trench is disposed with the third P-type semiconductor region In addition, each of the third P-type semiconductor regions is in contact with the second P-type semiconductor region, so that each of the third P-type semiconductor regions is connected to the second P-type semiconductor region to perform signal transmission, and a voltage of each of the third P-type semiconductor regions is the same as a voltage of the second P-type semiconductor region.

In this embodiment, a plurality of fourth P-type semiconductor regions are also disposed, and the plurality of fourth P-type semiconductor regions are disposed in a one-to-one correspondence and in contact with the plurality of third P-type semiconductor regions. One of the plurality of fourth P-type semiconductor regions is disposed in correspondence with the third P-type semiconductor region disposed on the first side wall, and the fourth P-type semiconductor region is disposed on a side that is of the third P-type semiconductor region and that is away from the first side wall of the first trench. The source is connected to the second P-type semiconductor region sequentially through the fourth P-type semiconductor region and the third P-type semiconductor region that are disposed in correspondence with each other, so that a voltage loaded on the source is input to the second P-type semiconductor region sequentially through the fourth P-type semiconductor region and the third P-type semiconductor region, the second P-type semiconductor region has a voltage, an electric field of a gate dielectric layer at a bottom of the trench structure can be effectively shielded, and working robustness of the device is improved.

In this embodiment, only the first side wall of the first trench is disposed with the fourth P-type semiconductor region, and the second side wall of the first trench is disposed with only the source region.

In some possible embodiments of this application, positions of the first side wall and the second side wall of the first trench may also be interchanged. To be specific, the second side wall of the first trench may be disposed with one of the plurality of third P-type semiconductor regions, and the first side wall of each first trench is not disposed with a third P-type semiconductor region.

In some possible implementations of this application, the semiconductor device may specifically include an N-type semiconductor substrate, an epitaxial layer, a trench structure, a gate, an interlayer dielectric layer, a source, and a drain. In addition, the epitaxial layer may include a first N-type semiconductor region, a second N-type semiconductor region, a first P-type semiconductor region, a source region, a second P-type semiconductor region, third P-type semiconductor regions, and fourth P-type semiconductor regions. This embodiment is a variant of the implementations in the foregoing embodiment. The following describes only differences between this embodiment and the foregoing embodiment, and the same parts are not described herein again.

In this embodiment, at least one end part of a second trench may extend out of a first trench located at an edge in the plurality of first trenches. In a second direction, the second trench may have a third side wall and a fourth side wall that are disposed opposite to each other, and the third P-type semiconductor region may be disposed on the third side wall and/or the fourth side wall of the second trench. For example, both end parts of the second trench may extend out of the first trench located at the edge in the plurality of first trenches, and the third P-type semiconductor regions may be disposed on the third side wall and the fourth side wall of the second trench. In other words, the third side wall and the fourth side wall of the second trench each are disposed with the third P-type semiconductor region. In addition, each of the third P-type semiconductor regions is in contact with the second P-type semiconductor region, so that each of the third P-type semiconductor regions is connected to the second P-type semiconductor region to perform signal transmission, and a voltage of each of the third P-type semiconductor regions is the same as a voltage of the second P-type semiconductor region. Correspondingly, the fourth P-type semiconductor region is disposed in a one-to-one correspondence and in contact with the third P-type semiconductor region. One fourth P-type semiconductor region is disposed in correspondence with the third P-type semiconductor region disposed on the third side wall, and the fourth P-type semiconductor region is disposed on a side that is of the third P-type semiconductor region and that is away from the third side wall of the second trench. In addition, one fourth P-type semiconductor region is disposed in correspondence with the third P-type semiconductor region disposed on the fourth side wall, and the fourth P-type semiconductor region is disposed on a side that is of the third P-type semiconductor region and that is away from the fourth side wall of the second trench. A voltage may be input to the second P-type semiconductor region sequentially through the fourth P-type semiconductor region and the third P-type semiconductor region, so that the second P-type semiconductor region has a voltage, an electric field of a gate dielectric layer at a bottom of the trench structure can be effectively shielded, and working robustness of the device is improved.

In this embodiment, the epitaxial layer may further include a fifth P-type semiconductor region. The fifth P-type semiconductor region and the source region are disposed at a same layer. The fifth P-type semiconductor region may be disposed on a side that is of a second side wall of the first trench and that is away from a first side wall. The fifth P-type semiconductor region may be further disposed on a side that is of the first side wall of the first trench and that is away from the second side wall, and the fifth P-type semiconductor region is in contact with the source through a contact hole.

In this embodiment, a plurality of fifth P-type semiconductor regions may be disposed, and the plurality of fifth P-type semiconductor regions are disposed in a one-to-one correspondence with the first side walls and the second side walls of all the first trenches. In addition, a plurality of source regions and a plurality of fifth P-type semiconductor regions that are located on first side walls of the first trenches are alternately disposed, and a plurality of source regions and a plurality of fifth P-type semiconductor regions that are located on second side walls of the first trenches are alternately disposed.

Optionally, the fifth P-type semiconductor region may be formed by doping the epitaxial layer by using an ion implantation process. In addition, the fifth P-type semiconductor region is mainly doped with a P-type impurity, for example, boron (B), aluminum (Al), or gallium (Ga). For example, a doping concentration of the fifth P-type semiconductor region may be the same as or similar to a doping concentration of the fourth P-type semiconductor region.

In this embodiment of this application, the third side wall and the fourth side wall of the second trench are disposed with the third P-type semiconductor regions, and no channel is formed.

In some possible implementations of this application, the semiconductor device may specifically include an N-type semiconductor substrate, an epitaxial layer, a trench structure, a gate, an interlayer dielectric layer, a source, and a drain. In addition, the epitaxial layer may include a first N-type semiconductor region, a second N-type semiconductor region, a first P-type semiconductor region, a source region, a second P-type semiconductor region, a third P-type semiconductor region, and a fourth P-type semiconductor region. This embodiment is a variant of the implementations in the foregoing embodiment. The following describes only differences between this embodiment and the foregoing embodiment, and the same parts are not described herein again.

In this embodiment of this application, in a part of the trench structure of two adjacent trench structures, the first trenches arranged in a first direction communicate with each other. To be specific, a plurality of first trenches may include a first gate trench and a second gate trench that communicate with each other in the first direction. The first gate trench and the second gate trench may be considered to be respectively located in two adjacent trench structures. For example, first edge trenches in two adjacent trench structures on the left and right sides are arranged in the first direction, and the two first edge trenches communicate with each other. Second edge trenches in two adjacent trench structures on the left and right sides are arranged in the first direction, and the two second edge trenches communicate with each other. For another example, a first trench in the middle of a left-side trench structure and a first trench in the middle of a right-side trench structure may also communicate with each other.

Correspondingly, a contact hole may include a plurality of contact sub-holes that are disposed at intervals, and at least one first trench that is through is disposed between two adjacent contact sub-holes in a same contact hole. A quantity of the contact sub-holes that the contact hole is divided into is not limited in this application. For example, there may be two, three, four, or more contact sub-holes. In addition, a quantity of first trenches that are through and that are disposed between two adjacent contact sub-holes in a same contact hole is not limited in this application. For example, there may be one, two, three, four, or more first trenches. In this way, design freedom of the contact hole can be improved, and through-current uniformity of a SiC MOSFET device can be improved.

In some possible implementations of this application, the semiconductor device may specifically include an N-type semiconductor substrate, an epitaxial layer, a trench structure, a gate, an interlayer dielectric layer, a source, and a drain. In addition, the epitaxial layer may include a third N-type semiconductor region, a first N-type semiconductor region, a second N-type semiconductor region, a first P-type semiconductor region, a source region, a second P-type semiconductor region, a third P-type semiconductor region, and a fourth P-type semiconductor region. This embodiment is a variant of the implementations in the foregoing embodiment. The following describes only differences between this embodiment and the foregoing embodiment, and the same parts are not described herein again.

In this embodiment, the third N-type semiconductor region may be disposed between the first N-type semiconductor region and the semiconductor substrate. Because the third N-type semiconductor region is disposed, a thickness of the second P-type semiconductor region at the epitaxial layer in the third direction may be set to be thicker. For example, the thickness of the second P-type semiconductor region in the third direction may be set to be greater than 1 µm.

In this embodiment, the third N-type semiconductor region may be SiC doped with an N-type impurity. The N-type impurity is, for example, nitrogen (N), phosphorus (P), or arsenic (As). For example, a doping concentration of the third N-type semiconductor region may be less than a doping concentration of the first N-type semiconductor region.

According to a second aspect, an embodiment of this application further provides a manufacturing method for a semiconductor device. The manufacturing method may include the following steps: epitaxially growing an epitaxial layer on an N-type semiconductor substrate; etching at the epitaxial layer to form a trench structure, where the trench structure includes a plurality of first trenches and one second trench, all of the plurality of first trenches extend in a first direction parallel to a plane on which the semiconductor substrate is located, and are arranged at intervals in a second direction parallel to the plane on which the semiconductor substrate is located, the second trench extends in the second direction, and the second trench and each of the plurality of first trenches are disposed in a cross manner and communicate with each other; sequentially forming a gate dielectric layer and a gate in the trench structure; forming, on the gate, an interlayer dielectric layer that covers the epitaxial layer; etching the interlayer dielectric layer to form a contact hole extending in the second direction, where the contact hole exposes a partial region of the epitaxial layer, a projection of the contact hole in a third direction does not overlap the gate, and the first direction, the second direction, and the third direction are set in a cross manner; forming a source at the interlayer dielectric layer, where the source is in contact, through the contact hole, with the epitaxial layer exposed by the contact hole; and forming a drain on a side that is of the semiconductor substrate and that is away from the epitaxial layer.

In some possible implementations, the manufacturing method may further include: before the sequentially forming a gate dielectric layer and a gate in the trench structure, forming, by using a tilted ion implantation process on at least one side wall of the trench structure, a third P-type semiconductor region in contact with a second P-type semiconductor region; and forming, at the epitaxial layer by using an ion implantation process, a fourth P-type semiconductor region disposed at a same layer as a source region.

In some possible implementations, to form the epitaxial layer, the epitaxially growing an epitaxial layer on an N-type semiconductor substrate may include the following steps:

First, an epitaxial layer that reaches a first specified thickness (that is, a thickness in the third direction) is epitaxially grown on the N-type SiC semiconductor substrate. For example, a SiC material doped with an N-type impurity is epitaxially grown on the N-type SiC semiconductor substrate by using an epitaxial growth process, to form the epitaxial layer that reaches the first specified thickness. A specific value of the first specified thickness is not limited in this application. In actual application, the specific value of the first specified thickness may be determined based on a requirement of an actual application environment.

Then, ion implantation is performed at the epitaxial layer by using the ion implantation process, to form a second P-type semiconductor region. For example, a P-type impurity is doped, by using the ion implantation process, in the to-be-formed second P-type semiconductor region at the epitaxial layer, to form the second P-type semiconductor region that is a planar region. A thickness of the second P-type semiconductor region (that is, a thickness in the third direction) is not limited in this application. In actual application, a specific value of the thickness of the second P-type semiconductor region may be determined based on a requirement of an actual application environment.

Then, epitaxial growth is continued at the epitaxial layer at which the second P-type semiconductor region is formed, until an epitaxial layer that reaches a second specified thickness is formed. For example, the SiC material doped with the N-type impurity continues to be epitaxially grown, by using the epitaxial growth process, at the epitaxial layer at which the second P-type semiconductor region is formed, to form the first epitaxial layer that reaches the second specified thickness.

In some possible implementations, after the epitaxially growing an epitaxial layer on an N-type semiconductor substrate, the manufacturing method may further include: performing ion implantation in a partial region of the epitaxial layer by using the ion implantation process, to sequentially form a second N-type semiconductor region, a first P-type semiconductor region, and the source region, where a region that is of the epitaxial layer and in which ion implantation is not performed forms a first N-type semiconductor region. For example, to form the second N-type semiconductor region, the first P-type semiconductor region, and the source region, the region that is of the epitaxial layer and in which ion implantation is not performed forms the first N-type semiconductor region. The performing ion implantation in a partial region of the epitaxial layer by using the ion implantation process, to sequentially form a second N-type semiconductor region, a first P-type semiconductor region, and the source region, where a region that is of the first epitaxial layer and in which ion implantation is not performed forms a first N-type semiconductor region may include the following steps:

The N-type impurity is doped on a surface of the epitaxial layer by using the ion implantation process, to form the second N-type semiconductor region. Then, the P-type impurity is doped on the surface of the epitaxial layer by using the ion implantation process, to form the first P-type semiconductor region. Then, the N-type impurity is doped on the surface of the epitaxial layer by using the ion implantation process, to form the source region, and the P-type impurity doped on a surface of the epitaxial layer that is on a first side wall and a second side wall of the first trench, to form the fourth P-type semiconductor region disposed at a same layer as the source region. Therefore, in this embodiment of this application, after the ion implantation process is performed, the partial region of the epitaxial layer forms the second N-type semiconductor region, the first P-type semiconductor region, the source region, and the fourth P-type semiconductor region, and the region that is of the epitaxial layer and in which ion implantation is not performed by using the ion implantation process forms the first N-type semiconductor region.

In some possible implementations, to form the trench structure, etching the epitaxial layer until the first N-type semiconductor region is etched, to form the trench structure at the epitaxial layer may include the following steps:

First, a trench mask is formed at the epitaxial layer (where the trench mask may be a mask formed by using photoresist or a hard mask plate). A region that is of the epitaxial layer and that does not need to form the trench structure is covered with the trench mask, and a region that is of the epitaxial layer and that needs to form the trench structure is exposed. Then, an appropriate etching process is selected from a plasma etching process, an ion sputtering etching process, a reactive ion etching process, and the like, to etch region that is of the epitaxial layer and that is not covered with the trench mask, and stop etching when the first N-type semiconductor region is etched and the second P-type semiconductor region is exposed, to form, at the epitaxial layer, the trench structure including the plurality of first trenches and the second trench.

In some possible implementations, to form the third P-type semiconductor region, separately forming, on the first side wall and the second side wall of each first trench in the first direction by using the tilted ion implantation process, the third P-type semiconductor region in contact with the second P-type semiconductor region may include the following steps:

The P-type impurity is doped on surfaces of the first side wall and the second side wall of each first trench by using the tilted ion implantation process, to separately form the third P-type semiconductor region in contact with the second P-type semiconductor region.

In some possible implementations, to form a gate dielectric layer, forming the gate dielectric layer in the trench structure may include the following steps: Oxidation processing is performed on a surface of the trench structure by using an oxidation process, so that the gate dielectric layer is formed on the surface of the trench structure.

In some possible implementations, to form the gate, forming the gate in the trench structure in which the gate dielectric layer is formed may include the following steps:

First, a polycrystalline silicon material is deposited, by using a deposition process, at the entire epitaxial layer at which the trench structure is formed, so that the polycrystalline silicon material is filled in the trench structure, and the entire epitaxial layer is covered with a polycrystalline silicon material film layer after the trench structure is filled with the polycrystalline silicon material. Then, an appropriate etching process is selected from a plasma etching process, an ion sputtering etching process, a reactive ion etching process, and the like, to etch a polycrystalline silicon material region that is not covered with the trench mask, and stop etching when the source region and the fourth P-type semiconductor region are exposed, to form the gate.

In some possible implementations, to form the interlayer dielectric layer, forming, on the gate, the interlayer dielectric layer that covers the entire epitaxial layer may include the following steps: The interlayer dielectric layer is deposited at the entire epitaxial layer by using the deposition process, and the interlayer dielectric layer covers the entire epitaxial layer.

In some possible implementations, to form the contact hole, the etching the interlayer dielectric layer to form a contact hole extending in the second direction, may include the following steps:

First, a mask of the contact hole is formed at the epitaxial layer (where the mask of the contact hole may be a mask formed by using photoresist or a hard mask plate). A region that does not need to form the contact hole is covered with the mask of the contact hole, and a region that needs to form the contact hole is exposed. Then, an appropriate etching process is selected from a plasma etching process, an ion sputtering etching process, a reactive ion etching process, and the like, to etch the region that is of the interlayer dielectric layer and that is not covered with the mask of the contact hole, expose a partial region of the source region, for example, parts of the source region that are in the first direction and that are located on two sides of the gate, and expose parts of the fourth P-type semiconductor region that are located on the two sides of the gate.

In some possible implementations, to form the source and the drain, forming the source at the interlayer dielectric layer, where the source is in contact with the source region through the contact hole, and forming the drain on the side that is of the semiconductor substrate and that is away from the epitaxial layer may include the following steps:

A metal material is deposited at the interlayer dielectric layer by using the deposition process, to form the source. The contact hole is filled with the metal material, so that the source is in contact with the source region by using the metal material filled in the contact hole. For example, before the source is formed, the metal material may be deposited, by using the deposition process, on the side that is of the semiconductor substrate and that is away from the epitaxial layer, to form the drain. Alternatively, after the source is formed, the metal material may be deposited, by using the deposition process, on the side that is of the semiconductor substrate and that is away from the epitaxial layer, to form the drain.

A material of the source and the drain is not limited in this application. For example, the material for forming the source and the drain may be a metal material. For example, the metal material may include W, Al, Ti, Cu, Mo, or Pt.

According to a third aspect, an embodiment of this application further provides a power conversion circuit. The power conversion circuit may be an alternating current-direct current conversion circuit and/or a direct current-direct current conversion circuit. The power conversion circuit may include a circuit board and one or more semiconductor devices, and the semiconductor device is connected to the circuit board. The semiconductor device may be the semiconductor device according to the first aspect or various possible designs of the first aspect, or the semiconductor device manufactured according to the second aspect or various possible designs of the second aspect. Because performance of the foregoing semiconductor device is good, performance of a power conversion circuit including the foregoing semiconductor device is also good. In addition, a problem-resolving principle of the power conversion circuit is similar to a problem-resolving principle of the foregoing semiconductor device. Therefore, for technical effects of the power conversion circuit, refer to technical effects of the foregoing semiconductor device. Repeated content is not described again.

According to a fourth aspect, an embodiment of this application further provides a vehicle, and the vehicle may include a power conversion circuit. The power conversion circuit may be the power conversion circuit according to the third aspect or various possible designs of the third aspect. Because performance of the foregoing power conversion circuit is good, circuit performance of a vehicle including the foregoing power conversion circuit is also good. In addition, a problem-resolving principle of the vehicle is similar to a problem-resolving principle of the foregoing power conversion circuit. Therefore, for technical effects of the vehicle, refer to technical effects of the foregoing power conversion circuit. Repeated content is not described again.

### BRIEF DESCRIPTION OF DRAWINGS

FIG. 1 is a diagram of a relationship between resistance of a channel region and resistance of a JFET region in a SiC MOSFET device;
FIG. 2a is a schematic diagram of a structure of an electric vehicle according to an embodiment of this application;
FIG. 2b is a schematic diagram of a structure of an electronic device according to an embodiment of this application;
FIG. 3 is a schematic diagram of a top-view structure of a semiconductor device according to an embodiment of this application;
FIG. 4 is a schematic diagram of a sectional-view structure in a tangential direction of A1A2 in FIG. 3;
FIG. 5 is a schematic diagram of a sectional-view structure in a tangential direction of A3A4 in FIG. 3;
FIG. 6 is a schematic diagram of a sectional-view structure in a tangential direction of V1V2 in FIG. 3;
FIG. 7 is a schematic diagram of a sectional-view structure in a tangential direction of V3V4 in FIG. 3;
FIG. 8 is a schematic diagram of a partial three-dimensional structure in FIG. 3;
FIG. 9 is a schematic diagram of a three-dimensional structure existing when a semiconductor device shown in FIG. 8 is not provided with an interlayer dielectric layer or a source;
FIG. 10 is a schematic diagram of a three-dimensional structure of a trench structure in a semiconductor device shown in FIG. 8;
FIG. 11 is some schematic diagrams when a semiconductor device according to an embodiment of this application generates a conduction current;
FIG. 12 is a schematic diagram of a sectional-view structure in a tangential direction of C1C2 in FIG. 11;
FIG. 13 is some flowcharts of a manufacturing method for a semiconductor device according to an embodiment of this application;
FIG. 14a to FIG. 14j each are a schematic structural diagram of a manufacturing process of a semiconductor device according to an embodiment of this application;
FIG. 15 is a schematic diagram of a three-dimensional structure of a semiconductor device according to another embodiment of this application;
FIG. 16 is a schematic diagram of a three-dimensional structure existing when a semiconductor device shown in FIG. 15 is not provided with an interlayer dielectric layer or a source;
FIG. 17 is a schematic diagram of a structure of a trench structure in a semiconductor device shown in FIG. 15;
FIG. 18 is a schematic diagram of a three-dimensional structure of a semiconductor device according to still another embodiment of this application;
FIG. 19 is a schematic diagram of a three-dimensional structure existing when a semiconductor device shown in FIG. 18 is not provided with an interlayer dielectric layer or a source;
FIG. 20 is a schematic diagram of a three-dimensional structure of a trench structure in a semiconductor device shown in FIG. 18;
FIG. 21 is a schematic diagram of a three-dimensional structure of a semiconductor device according to still another embodiment of this application;
FIG. 22 is a schematic diagram of a three-dimensional structure existing when a semiconductor device shown in FIG. 21 is not provided with an interlayer dielectric layer or a source;
FIG. 23 is a schematic diagram of a three-dimensional structure of a trench structure in a semiconductor device shown in FIG. 21;
FIG. 24 is a schematic diagram of a top-view structure of a semiconductor device according to another embodiment of this application;
FIG. 25 is a schematic diagram of a sectional-view structure in a tangential direction of B1B2 in FIG. 24;
FIG. 26 is a schematic diagram of a sectional-view structure in a tangential direction of B3B4 in FIG. 24;
FIG. 27 is a schematic diagram of a sectional-view structure in a tangential direction of X1X2 in FIG. 24;
FIG. 28 is a schematic diagram of a sectional-view structure in a tangential direction of X3X4 in FIG. 24;
FIG. 29 is a schematic diagram of a partial three-dimensional structure in FIG. 24;
FIG. 30 is a schematic diagram of a three-dimensional structure existing when a semiconductor device shown in FIG. 29 is not provided with an interlayer dielectric layer or a source;
FIG. 31 is a schematic diagram of a partial three-dimensional structure of a semiconductor device shown in FIG. 30;
FIG. 32 is a schematic diagram of a top-view structure of a semiconductor device according to another embodiment of this application;
FIG. 33 is a schematic diagram of a top-view structure of a semiconductor device according to still another embodiment of this application; and
FIG. 34 is a schematic diagram of a three-dimensional structure of a semiconductor device according to still another embodiment of this application.

### Reference numerals:

010: electric vehicle; 012: storage battery; 0100: electronic device; 0110: power conversion circuit; 0120: load module; 0200: power supply; 0111: DC-DC converter; 1: semiconductor substrate; 100: epitaxial layer; 2: first N-type semiconductor region; 3: second N-type semiconductor region; 4: first P-type semiconductor region; 5: fourth P-type semiconductor region; 6: source region; 7: trench structure; 8: second P-type semiconductor region; 9: third P-type semiconductor region; 10: gate dielectric layer; 11: gate; 12: interlayer dielectric layer; 13: source; 14: drain; 15: fifth P-type semiconductor region; 16: third N-type semiconductor region; 202: spacing region; 71: first trench; 72: second trench; 121: contact hole; x: first direction; y: second direction; z: third direction; C: trench spacing; D: trench length; E: trench width; F: contact width; S1: first side wall; S2: second side wall; S3: third side wall; S4: fourth side wall; DS1: first specified thickness; DS2: second specified thickness.

### DESCRIPTION OF EMBODIMENTS

To make the objectives, technical solutions, and advantages of this application clearer, the following further describes this application in detail with reference to the accompanying drawings. A specific operation method in method embodiments may also be applied to an apparatus embodiment or a system embodiment. It should be noted that, in the description of this application, "at least one" means one or more, and "a plurality of" means two or more. In view of this, in embodiments of this application, "a plurality of" may also be understood as "at least two". The term "and/or" describes an association relationship between associated objects and indicates that three relationships may exist. For example, A and/or B may indicate the following cases: Only A exists, both A and B exist, and only B exists, where A and B may be singular or plural. In addition, the character "/", unless otherwise specified, usually indicates an "or" relationship between the associated objects. In addition, it should be understood that terms such as "first" and "second" in the description of this application are merely used for distinguishing and description, but should not be understood as indicating or implying relative importance, or should not be understood as indicating or implying a sequence.

It should be noted that "connection" in embodiments of this application means an electrical connection, and a connection of two electrical components may be a direct or indirect connection between two electrical components. For example, a connection between A and B may be either a direct connection between A and B, or an indirect connection between A and B through one or more other electrical components. For example, the connection between A and B may be that A and C are directly connected, C and B are directly connected, and A and B are connected through C.

However, example implementations may be implemented in a plurality of forms and should not be construed as being limited to implementations described herein, but instead, these implementations are provided to make this application thorough and complete, and to fully convey the concept of the example implementations to a person skilled in the art. A same reference sign denotes a same or similar structure in the drawings, and therefore repeated descriptions thereof are omitted. The words expressing a position and a direction described in this application are all described by using the accompanying drawings as an example, but changes may also be made as required, and all the changes fall within the protection scope of this application. The accompanying drawings in this application are merely used to illustrate relative positional relationships and do not represent a real scale.

It should be noted that specific details are set forth in the following description to provide a thorough understanding of this application. However, this application can be implemented in numerous other manners different from those described herein, and a person skilled in the art can make similar inferences without departing from the connotation of this application. Therefore, this application is not limited to the specific implementations disclosed below. Example implementations of this application are subsequently described in this specification, but the description is intended to describe general principles of this application and is not intended to limit the scope of this application.

To facilitate understanding of a semiconductor device, a manufacturing method thereof, a power conversion circuit, and a vehicle that are provided in embodiments of this application, the following first describes an application scenario of the semiconductor device.

The semiconductor device provided in embodiments of this application may be used in a vehicle (for example, an electric vehicle), for example, may be used in an on-board micro controller unit (micro controller unit, MCU) or an on-board battery charger (on-board battery charger, OBC). It should be noted that the semiconductor device provided in embodiments of this application is intended to include but is not limited to being used in these devices and any other device of a proper type. The following provides descriptions by using an example in which the vehicle is an electric vehicle.

FIG. 2a is a schematic diagram of a structure of an electric vehicle according to an embodiment of this application. Refer to FIG. 2a. The electric vehicle 010 may include a power conversion circuit 0110 and a storage battery 012.

In a possible implementation, the power conversion circuit 0110 may include an alternating current (Alternating Current, AC)-direct current (Direct Current, DC) conversion circuit and a DC-DC conversion circuit, and the power conversion circuit 0110 may also be referred to as an inverter. For example, when the electric vehicle is charged, the electric vehicle 010 may be connected to a three-phase power grid, and receive a three-phase alternating current supplied by the three-phase power grid. A power switching transistor of the AC-DC conversion circuit of the power conversion circuit 0110 is controlled to work, so that the AC-DC conversion circuit can convert the three-phase alternating current into the direct current. A power switching transistor of the DC-DC conversion circuit of the power conversion circuit 0110 is controlled to work, so that the DC-DC conversion circuit can perform voltage regulation on the direct current output by the AC-DC conversion circuit, to supply a voltage-adapted direct current to the storage battery 012. In this way, the storage battery 012 can store the direct current, and a function of charging can be implemented.

In another possible implementation, the power conversion circuit 0110 may alternatively be the DC-DC conversion circuit, and the electric vehicle 010 may further include a load 013. The load 013 may be a vehicle-mounted device, a power system, or the like of the electric vehicle 010. For example, the power switching transistor of the DC-DC conversion circuit of the power conversion circuit 0110 is controlled to work, so that the power conversion circuit 0110 can perform voltage regulation on a direct current output by the storage battery and then output the direct current to the load 013, to supply the voltage-adapted direct current to the load 013.

A semiconductor device provided in embodiments of this application is a MOSFET of a trench gate structure. A density of a conduction channel can be increased, and resistance of a JFET region is not increased, so that total on-resistance is reduced, device performance is improved, and a device loss is reduced. For example, the semiconductor device provided in embodiments of this application may be used in a power conversion circuit 0110 of a vehicle as a power switching transistor of an AC-DC converter and/or a DC-DC converter. Because device performance of the semiconductor device provided in embodiments of this application is good, when the semiconductor device is used in the AC-DC converter and/or the DC-DC converter, performance of the AC-DC converter and/or the DC-DC converter can be improved and a drive loss can be reduced, so that performance of the entire circuit is improved and the drive loss is reduced.

The semiconductor device provided in embodiments of this application may also be widely used in various electronic devices, for example, may be used in an electronic device having a logic device or a storage device. For example, the electronic device may be a smartphone, a smart television, a notebook computer, a personal digital assistant (personal digital assistant, PDA), a wearable device (for example, a smartwatch, smart glasses, or a smart band) having a wireless communication function, or the like. It should be noted that the semiconductor device provided in embodiments of this application is intended to include but is not limited to being used in these electronic devices and any other electronic device of a proper type.

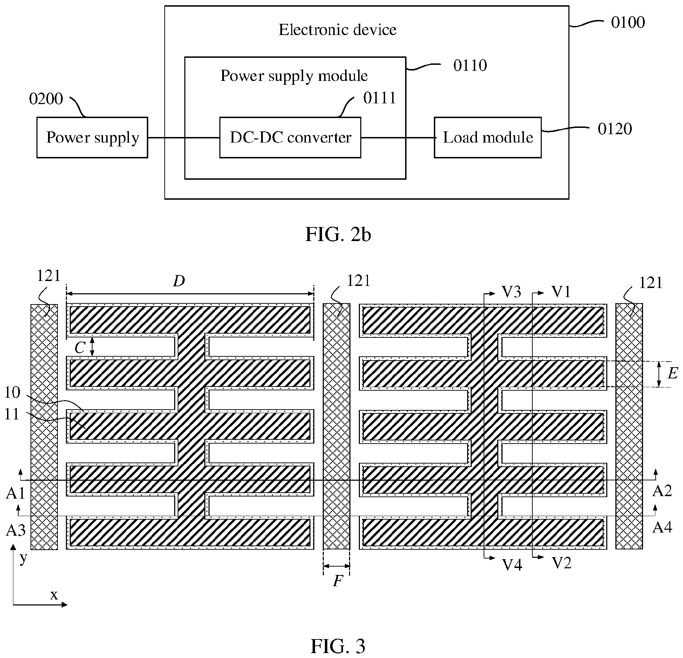

FIG. 2b is a schematic diagram of a structure of an electronic device according to an embodiment of this application. Refer to FIG. 2b, the electronic device 0100 provided in this embodiment of this application includes a power conversion circuit 0110 and a load module 0120. The power conversion circuit 0110 is electrically connected to the load module 0120. For example, the electronic device 0100 may be any electric device. For example, the electronic device 0100 may be a smartphone, a smart television, a notebook computer, a personal digital assistant (personal digital assistant, PDA), a wearable device (for example, a smartwatch, smart glasses, or a smart band) having a wireless communication function, an on-board micro controller unit (micro controller unit, MCU), or an on-board battery charger (on-board battery charger, OBC). It should be noted that a specific type of the electronic device is not limited in this application.

In some embodiments, the power conversion circuit 0110 may be a direct current (direct current, DC)-direct current power conversion circuit, and is configured to output a direct current after performing boost or buck conversion processing on the direct current, to supply power to the load module 0120. For example, the power conversion circuit 0110 may convert a direct current (for example, 48 V) output by a power supply 0200 into a direct current used for all types of load modules 0120, and output the direct current to the load module 0120, so that the load module 0120 works. The power supply 0200 and the load module 0120 are not limited in this application. The power supply 0200 may be any device or component that can output a direct current. For example, the power supply 0200 may be a battery (for example, a storage battery). In this case, the power conversion circuit 0110 may receive a battery voltage supplied by the battery, convert the battery voltage into a working voltage of the load module 0120, and output the working voltage to the load module 0120. The load module 0120 may be any function module that uses a direct current. For example, the load module 0120 may be a processor, a chip, or the like.

Refer to FIG. 2a. The power conversion circuit 0110 may include a DC-DC converter 0111. In specific working, a MOSFET in the DC-DC converter 0111 works at a specific switching frequency, so that the DC-DC converter 0111 performs boost or buck conversion processing on a direct current of the power supply 0200, and then outputs the direct current to the load module 0120, to supply a direct current of the working voltage. For example, the DC-DC converter may be, for example, a Buck (buck) converter, a Boost (boost) converter, a half-bridge converter, a full-bridge converter, and an inductor-inductor-capacitor (inductor-inductor-capacitor, LLC) resonant converter.

A semiconductor device provided in embodiments of this application is a MOSFET of a trench gate structure. A density of a conduction channel can be increased, and resistance of a JFET region is not increased, so that total on-resistance is reduced, device performance is improved, and a device loss is reduced. For example, the semiconductor device provided in embodiments of this application may be used in the DC-DC converter 0111 as a MOSFET in the DC-DC converter 0111. Because device performance of the semiconductor device provided in embodiments of this application is good, when the semiconductor device is used in the MOSFET in the DC-DC converter 0111, performance of the DC-DC converter 0111 can be improved and a drive loss can be reduced, so that performance of the entire electronic device is improved and the drive loss is reduced.

It should be noted that the foregoing scenario description is merely an example of some implementable application manners of the semiconductor device in this application. A specific application scenario of the semiconductor device provided in embodiments of this application is not limited in this application, and may be determined based on an actual application requirement.

In some embodiments provided in this application, materials of a semiconductor substrate 1 and an epitaxial layer 100 may be SiC. In this case, the semiconductor device provided in embodiments of this application is a SiC MOSFET.

It should be noted that, in this application, at a layer with a prefix of N or P and in a region with a prefix of N or P, N or P respectively indicates that an electron or a hole is a majority carrier. In addition, "+" marked beside N or P indicates a higher doping concentration than a doping concentration of a layer or region not marked with "+", and a larger quantity of "+" indicates a higher doping concentration. In addition, Ns or Ps that include a same quantity of "+" indicate similar doping concentrations not limited to a same doping concentration. In addition, "-" marked beside N or P indicates a lower doping concentration than a doping concentration of a layer or region not marked with "-", and a larger quantity of "-" indicates a lower doping concentration. Ns or Ps that include a same quantity of "-" indicate similar doping concentrations not limited to a same doping concentration.

In addition, it should be further noted that, in this application, a comparison between doping concentrations of two regions is merely a comparison between concentrations of impurities doped in the two regions. A component of an impurity and a material of a substrate doped with the impurity are not limited. In other words, components of the impurities may be the same or may be different. Materials of substrates doped with the impurities may be the same or may be different.

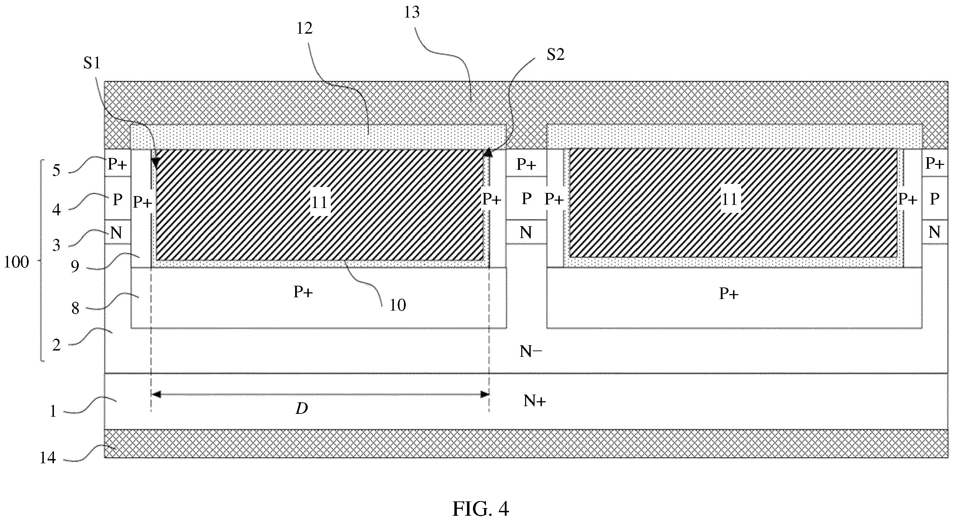

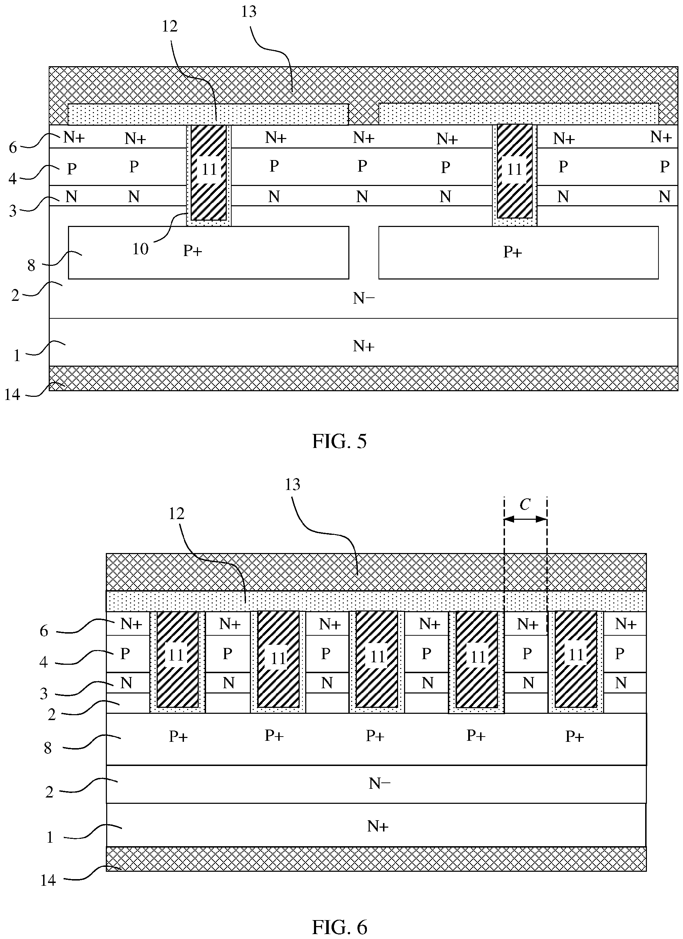

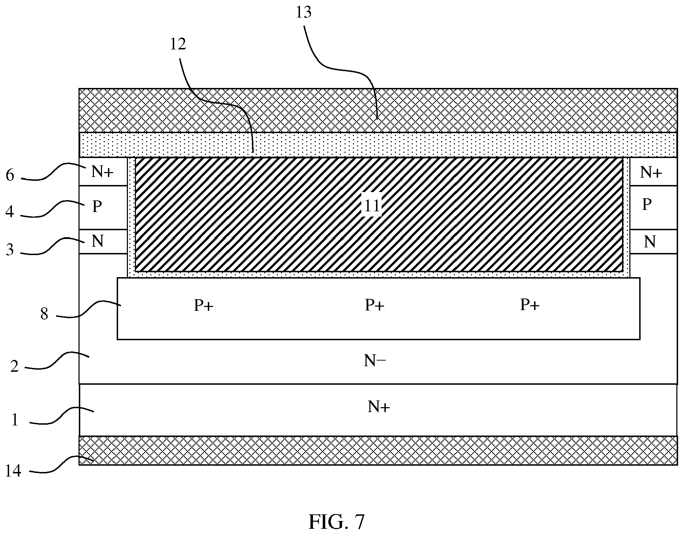

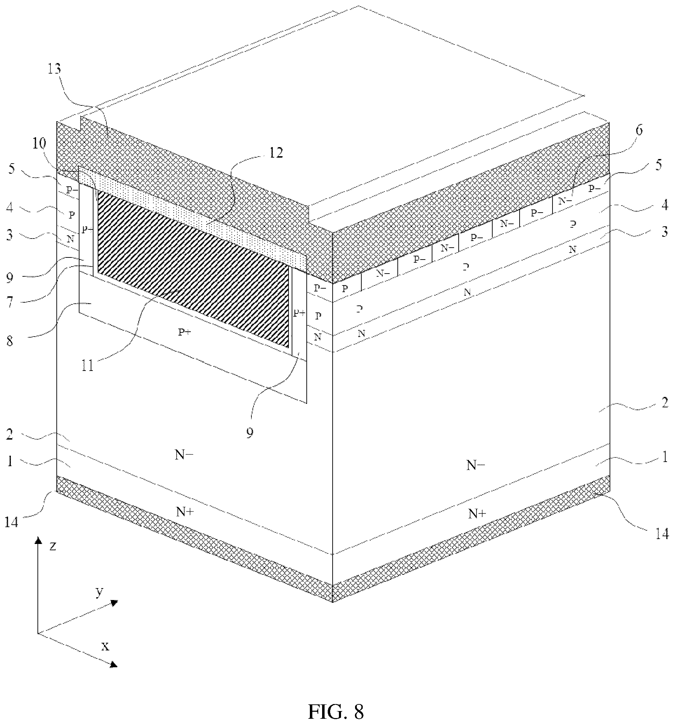

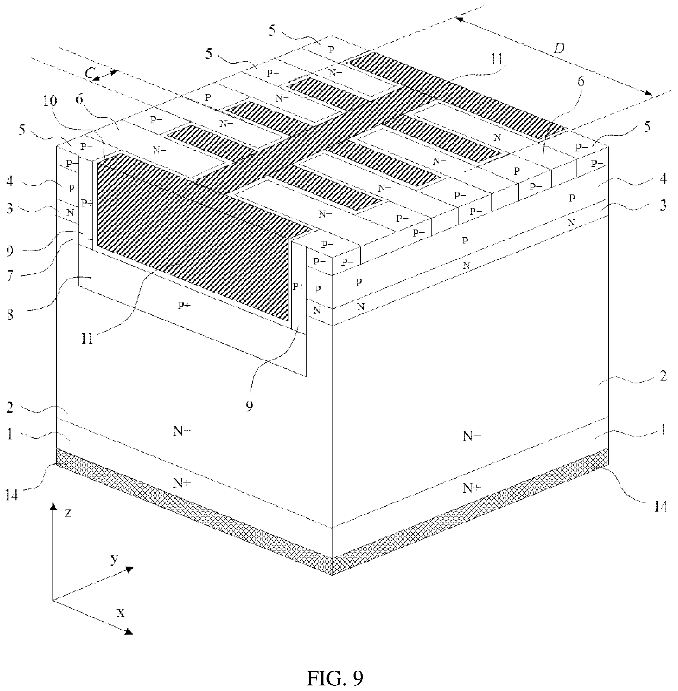

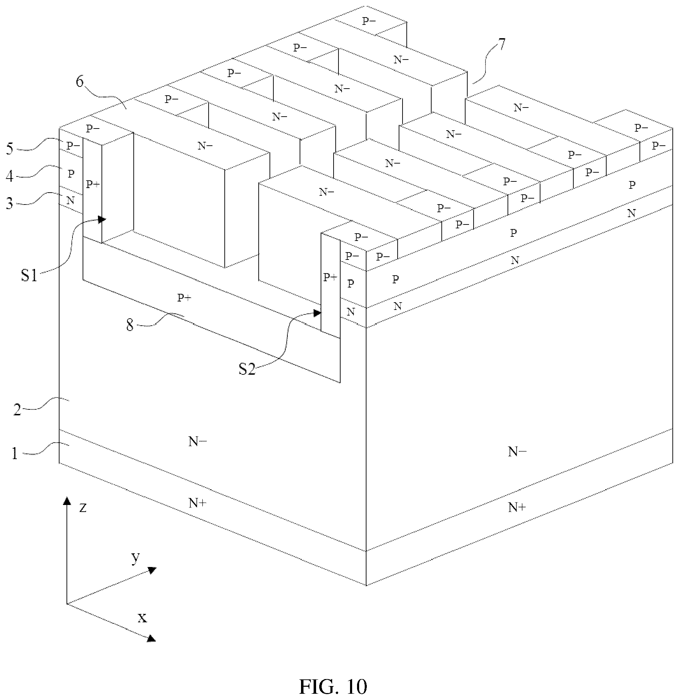

FIG. 3 shows a schematic diagram of a top-view structure of a semiconductor device according to an embodiment of this application. FIG. 4 shows a schematic diagram of a sectional-view structure in a tangential direction of A1A2 in FIG. 3. FIG. 5 shows a schematic diagram of a sectional-view structure in a tangential direction of A3A4 in FIG. 3. FIG. 6 shows a schematic diagram of a sectional-view structure in a tangential direction of V1V2 in FIG. 3. FIG. 7 shows a schematic diagram of a sectional-view structure in a tangential direction of V3V4 in FIG. 3. FIG. 8 shows a schematic diagram of a partial three-dimensional structure in FIG. 3. FIG. 9 shows a schematic diagram of a three-dimensional structure existing when the semiconductor device shown in FIG. 8 is not provided with an interlayer dielectric layer 12 or a source 13. FIG. 10 shows a schematic diagram of a three-dimensional structure of a trench structure in the semiconductor device shown in FIG. 8.

Refer to FIG. 3 to FIG. 10. The semiconductor device provided in this embodiment of this application may specifically include an N-type semiconductor substrate 1, an epitaxial layer 100, a trench structure 7, a gate 11, an interlayer dielectric layer 12, a source 13, and a drain 14. For example, the epitaxial layer 100 includes a first N-type semiconductor region 2, a second N-type semiconductor region 3, a first P-type semiconductor region 4, and a source region 6 that are sequentially disposed on the semiconductor substrate 1.

In this application, the semiconductor substrate 1 may be a SiC single crystal substrate doped with a pentavalent element. A SiC material that is generated through epitaxial growth and that is doped with a corresponding impurity may be used for the epitaxial layer 100. For example, the first N-type semiconductor region 2 may be a partial region of the epitaxial layer 100 formed through epitaxial growth, and the second N-type semiconductor region 3 and the source region 6 may be formed by doping the epitaxial layer 100 by using an ion implantation process. In addition, the N-type semiconductor region is mainly doped with an N-type impurity, for example, nitrogen (N), phosphorus (P), or arsenic (As). For example, a doping concentration of the semiconductor substrate 1 is usually greater than a doping concentration of the second N-type semiconductor region 3, a doping concentration of the second N-type semiconductor region 3 is usually greater than a doping concentration of the first N-type semiconductor region 2, and a doping concentration of the source region 6 is usually greater than a doping concentration of the second N-type semiconductor region 3.

In this application, the first P-type semiconductor region 4 may be formed by doping the epitaxial layer 100 by using the ion implantation process. In addition, the P-type semiconductor region is mainly doped with a P-type impurity, for example, boron (B), aluminum (Al), or gallium (Ga).

Still refer to FIG. 3 to FIG. 10. The trench structure 7 is disposed at the epitaxial layer 100, and in a third direction z perpendicular to a plane on which the semiconductor substrate 1 is located, the trench structure 7 extends to the first N-type semiconductor region 2. The trench structure 7 may specifically include a plurality of first trenches 71 and one second trench 72. All of the plurality of first trenches 71 extend in a first direction x parallel to the plane on which the semiconductor substrate 1 is located, and are arranged at intervals in a second direction y parallel to the plane on which the semiconductor substrate 1 is located. The second trench 72 extends in the second direction y, and the second trench 72 and each of the plurality of first trenches 71 are disposed in a cross manner and communicate with each other. A main function of the second trench 72 is to connect the first trenches 71. The tightly arranged trench structure 7 may be formed by disposing the first trench 71 and the second trench 72 at the epitaxial layer 100. The first direction x, the second direction y, and the third direction z are set in a cross manner. For example, the first direction x, the second direction y, and the third direction z are set to be perpendicular to each other.

Still refer to FIG. 3 to FIG. 10. The gate 11 is filled and disposed in the trench structure 7, and is spaced apart by a gate dielectric layer 10. Parts that are of the gate 11 and that are disposed in the plurality of first trenches 71 extend in the first direction x, and parts that are of the gate 11 and that are disposed in the second trench 72 extend in the second direction y, and are configured to connect the parts that are of the gate 11 and that extend in the first direction x. Existence of the trench structure 7 enables the gate 11 to be built inside the epitaxial layer 100 of the SiC material. The gate 11 and the first P-type semiconductor region 4 form a trench gate structure of a SiC MOSFET device by using the gate dielectric layer 10, so that the semiconductor device provided in this embodiment of this application is a SiC MOSFET of the trench gate structure.

A material of the gate 11 is not limited in this application. For example, the material of the gate 11 may be a polycrystalline silicon material, or may be another material having a good conductive property, for example, metal (for example, W, Al, Ti, Cu, Mo, or Pt).

Still refer to FIG. 3 to FIG. 10. The interlayer dielectric layer 12 is disposed on the gate 11 and covers the gate 11. The source 13 is disposed at the interlayer dielectric layer 12. In other words, the source 13 covers the entire interlayer dielectric layer 12. The drain 14 is disposed on a side that is of the semiconductor substrate 1 and that is away from the epitaxial layer 100. In other words, the drain 14 covers a side that is of the semiconductor substrate 1 and that is not disposed with an epitaxial layer 100. In actual application, if a signal needs to be transmitted between the source 13 and the drain 14, a contact hole 121 extending in the second direction y may be disposed in the interlayer dielectric layer 12. To avoid contact between the source 13 and the gate 11, a projection of the contact hole 121 in the third direction z may not overlap the gate 11. In other words, the contact hole 121 does not overlap the gate 11. In addition, the contact hole 121 exposes a partial region of the source region 6. For example, the contact hole 121 may expose a part, of the source region 6, that is located on two sides of the gate 11 and that is in the first direction x, so that the source 13 can be in contact with the source region 6 through the contact hole 121, and effect of connecting the source 13 to the source region 6 is implemented. When the gate 11 controls a channel to be conducted, a signal may be transmitted between the source 13 and the drain 14, where parts of two side walls that are of each first trench 71 in the trench structure 7 and that are disposed opposite to each other in the second direction y are channels.

A material for forming the interlayer dielectric layer 12 is not limited in this application. For example, the material for forming the interlayer dielectric layer 12 may be a dielectric material. The dielectric material includes but is not limited to silicon dioxide (SiO₂), silicon nitride (SiNO), silicon carbon oxide (SiCO), silicon nitride (SiNx), and the like.

A material for forming the source 13 and the drain 14 is not limited in this application. For example, the material for forming the source 13 and the drain 14 may be a metal material. For example, the metal material may include W, Al, Ti, Cu, Mo, Pt, or the like.

According to the semiconductor device provided in this embodiment of this application, because an extension direction of the contact hole 121 disposed in the interlayer dielectric layer 12 is the second direction y, and an extension direction of each first trench 71 in the trench structure 7 is the first direction x, the extension direction of the contact hole 121 is perpendicular to the extension direction of each first trench 71. In other words, the contact hole 121 is disposed in a direction perpendicular to a first channel 71. Therefore, in comparison with a manner, in a conventional technology, in which the trench structure is disposed in parallel to the contact hole, according to the semiconductor device provided in this embodiment of this application, a limitation imposed by the contact hole 121 on a trench spacing C between adjacent first trench 71 in the second direction y is reduced, so that the trench structure can be manufactured more tightly. In other words, the gate 11 is also tighter. Therefore, an array density of the trench structure of the semiconductor device provided in this embodiment of this application may be far higher than an array density of a trench structure of a device structure in a conventional technology. Therefore, a channel density of the SiC MOSFET is increased, total on-resistance of the device is clearly reduced, device performance is improved, and a device loss is reduced.

In some embodiments of this application, there may be a plurality of trench structures 7 and a plurality of contact holes 121 in the semiconductor device. Specifically, one trench structure 7 may be disposed between two adjacent contact holes 121, so that signals can evenly flow. For example, refer to FIG. 3 to FIG. 5, two trench structures 7 and three contact holes 121 are illustrated. When there are a plurality of trench structures 7, structural parameters of the trench structures 7 may be the same, to ensure that the trench structures 7 are evenly distributed. For example, quantities of first trenches 71 may be the same, trench spacings between the first trenches 71 may be the same, trench lengths of the first trenches 71 may be the same, and lengths of the second trenches 72 may be the same. For example, refer to FIG. 3. The two trench structures 7 each are disposed with five first trenches 71. It should be noted that the quantity of first trenches 71 disposed in the trench structure 7 shown in FIG. 3 is merely for explanation and description, and does not limit a quantity of first trenches 71 in an actually manufactured semiconductor device. In actual application, the quantity of first trenches 71 in the trench structure 7 may be determined based on an actual application requirement. This is not limited in this application.

In some embodiments of this application, alternatively, quantities of first trenches 71 in some trench structures 7 may be the same, and quantities of first trenches 71 in the other trench structures 7 may be different. Alternatively, quantities of first trenches 71 in different trench structures 7 may be different. In actual application, the quantity of first trenches 71 in the trench structure 7 may be determined based on an actual application requirement. This is not limited in this application.

In some embodiments of this application, in the second direction y, two first trenches 71 that are located at edges of the trench structure 7 may be respectively defined as a first edge trench and a second edge trench, and the contact hole 121 extends, in the second direction, from a side that is of the first edge trench and that is away from the second edge trench to a side that is of the second edge trench and that is away from the first edge trench. For example, refer to FIG. 3. In the second direction y, two first trenches 71 that are located at upper and lower edges of the two trench structures 7 are respectively defined as the first edge trench and the second edge trench, and the contact hole 121 extends, in the second direction y, from the side that is of the first edge trench and that is away from the second edge trench to the side that is of the second edge trench and that is away from the first edge trench. In other words, the contact hole 121 is a continuous opening, and first trenches 71 in different trench structures 7 do not communicate with each other.

The semiconductor device provided in this embodiment of this application is a SiC MOSFET device of the trench gate structure. In the SiC MOSFET device of the trench gate structure, the gate dielectric layer 10 at a bottom and a corner of the trench structure 7 of the SiC MOSFET device bears extremely high electric field strength when the device works, is a weak point for electric field breakdown, and easily causes a reliability failure when the device works for a long period. Therefore, how to effectively shield the gate dielectric layer 10 from a high electric field stress becomes a key to a high robustness/reliability design of the device.

Based on this, in this embodiment of this application, refer to FIG. 3 to FIG. 10. A second P-type semiconductor region 8 may be further disposed at the epitaxial layer 100. The second P-type semiconductor region 8 is disposed below the trench structure 7, and the second P-type semiconductor region 8 may be connected to the source 13. In some embodiments of this application, the second P-type semiconductor region 8 may be disposed in direct contact with the bottom of the trench structure 7. When the SiC MOSFET device works, a voltage is loaded on the source 13. Because the second P-type semiconductor region 8 is connected to the source 13, the voltage loaded on the source 13 is input to the second P-type semiconductor region 8, so that the second P-type semiconductor region 8 also has a corresponding voltage, an electric field of the gate dielectric layer 10 at the bottom of the trench structure 7 can be effectively shielded, and working robustness of the device is improved.

For example, when the SiC MOSFET provided in this embodiment of this application is used in an electronic device, the source 13 of the SiC MOSFET may be grounded, and the drain 14 of the SiC MOSFET may be connected to another component. In this case, the voltage of the source 13 of the SiC MOSFET is a ground voltage (0 V). Because the second P-type semiconductor region 8 is connected to the source 13, the voltage of the second P-type semiconductor region 8 is also a ground voltage, so that the electric field of the gate dielectric layer 10 at the bottom of the trench structure 7 can be effectively shielded, and working robustness of the device is improved.

For example, when the SiC MOSFET provided in this embodiment of this application is used in an electronic device, the source 13 of the SiC MOSFET may alternatively be connected to another component, and the drain 14 of the SiC MOSFET may also be connected to another component. In this case, the voltage of the source 13 of the SiC MOSFET is a voltage of a signal input by the another component. Because the second P-type semiconductor region 8 is connected to the source 13, the voltage of the second P-type semiconductor region 8 is also the voltage of the input signal, so that the electric field of the gate dielectric layer 10 at the bottom of the trench structure 7 can be effectively shielded, and working robustness of the device is improved.

A thickness of the second P-type semiconductor region 8 in the third direction x is not limited in this application. In some embodiments of this application, a thickness range of the second P-type semiconductor region 8 in the third direction z may be less than 1 µm. For example, the thickness range of the second P-type semiconductor region 8 in the third direction z may be 0.3 µm to 0.8 µm.

In some embodiments of this application, refer to FIG. 4 and FIG. 8 to FIG. 10. The epitaxial layer 100 may further include a third P-type semiconductor region 9 and a fourth P-type semiconductor region 5. The third P-type semiconductor region 9 is disposed on at least one side wall of the trench structure 7, and the fourth P-type semiconductor region 5 and the source region 6 are disposed at a same layer. The third P-type semiconductor region 9 is in contact with the second P-type semiconductor region 8. The fourth P-type semiconductor region 5 and the third P-type semiconductor region 9 are disposed in a one-to-one correspondence and are in contact with each other. The voltage may be input to the second P-type semiconductor region 8 sequentially through the fourth P-type semiconductor region 5 and the third P-type semiconductor region 9, so that the electric field of the gate dielectric layer 10 at the bottom of the trench structure 7 can be effectively shielded, and working robustness of the device is improved.

Specifically, the first P-type semiconductor region 4, the second P-type semiconductor region 8, the third P-type semiconductor region 9, and the fourth P-type semiconductor region 5 may be formed by doping the epitaxial layer 100 by using the ion implantation process. In addition, the P-type semiconductor region is mainly doped with a P-type impurity, for example, boron (B), aluminum (Al), or gallium (Ga).

For example, doping concentrations of the second P-type semiconductor region 8, the third P-type semiconductor region 9, and the fourth P-type semiconductor region 5 are greater than a doping concentration of the first P-type semiconductor region 4. Optionally, the doping concentrations of the second P-type semiconductor region 8, the third P-type semiconductor region 9, and the fourth P-type semiconductor region 5 may be the same or similar. Certainly, at least two of the doping concentrations of the second P-type semiconductor region 8, the third P-type semiconductor region 9, and the fourth P-type semiconductor region 5 may alternatively be different. It should be noted that the doping concentrations of the second P-type semiconductor region 8, the third P-type semiconductor region 9, and the fourth P-type semiconductor region 5 may be determined based on a requirement of an actual application environment. This is not limited herein.

In some embodiments of this application, refer to FIG. 4 and FIG. 10. In the first direction x, each of the plurality of first trenches 71 may have a first side wall S1 and a second side wall S2 that are disposed opposite to each other, and the third P-type semiconductor regions 9 may be disposed on a first side wall S1 and a second side wall S2 of at least one of the plurality of first trenches 71. In other words, the first side wall S1 and the second side wall S2 of at least one first trench 71 each are disposed with the third P-type semiconductor region 9. In addition, each of the third P-type semiconductor regions 9 is in contact with the second P-type semiconductor region 8, so that each of the third P-type semiconductor regions 9 is connected to the second P-type semiconductor region 8 to perform signal transmission, and a voltage of each of the third P-type semiconductor regions 9 is the same as a voltage of the second P-type semiconductor region 8. Correspondingly, the fourth P-type semiconductor region 5 is disposed in a one-to-one correspondence and in contact with the third P-type semiconductor region 9, and the fourth P-type semiconductor region 5 may be in contact with the corresponding source 13 through the contact hole 121. One fourth P-type semiconductor region 5 is disposed in correspondence with the third P-type semiconductor region 9 disposed on the first side wall S1, and the fourth P-type semiconductor region 5 is disposed on a side that is of the third P-type semiconductor region 9 and that is away from the first side wall S1 of the first trench 71. In addition, one fourth P-type semiconductor region 5 is disposed in correspondence with the third P-type semiconductor region 9 disposed on the second side wall S2, and the fourth P-type semiconductor region 5 is disposed on a side that is of the third P-type semiconductor region 9 and that is away from the second side wall S2 of the first trench 71. The source 13 is connected to the second P-type semiconductor region 8 sequentially through the fourth P-type semiconductor region 5 and the third P-type semiconductor region 9 that are disposed in correspondence with each other, so that the voltage loaded on the source 13 is input to the second P-type semiconductor region 8 sequentially through the fourth P-type semiconductor region 5 and the third P-type semiconductor region 9, the second P-type semiconductor region 8 has the voltage, the electric field of the gate dielectric layer 10 at the bottom of the trench structure 7 can be effectively shielded, and working robustness of the device is improved.

In some embodiments of this application, a plurality of third P-type semiconductor regions 9 may be disposed. The first side wall S1 of each first trench 71 is disposed with one of the plurality of third P-type semiconductor regions 9, and the second side wall S2 of each first trench 71 is disposed with one of the plurality of third P-type semiconductor regions 9. In other words, the first side wall S1 and the second side wall S2 of each first trench 71 each are disposed with the third P-type semiconductor region 9. In addition, each of the third P-type semiconductor regions 9 is in contact with the second P-type semiconductor region 8, so that each of the third P-type semiconductor regions 9 is connected to the second P-type semiconductor region 8 to perform signal transmission, and the voltage of each of the third P-type semiconductor regions 9 is the same as the voltage of the second P-type semiconductor region 8. Correspondingly, a plurality of fourth P-type semiconductor regions 5 may be disposed. The plurality of fourth P-type semiconductor regions 5 are disposed in a one-to-one correspondence and in contact with the plurality of third P-type semiconductor regions 9. One of the plurality of fourth P-type semiconductor regions 5 is disposed in correspondence with the third P-type semiconductor region 9 disposed on the first side wall S1, and the fourth P-type semiconductor region 5 is disposed on the side that is of the third P-type semiconductor region 9 and that is away from the first side wall S1 of the first trench 71. In addition, one of the plurality of fourth P-type semiconductor regions 5 is disposed in correspondence with the third P-type semiconductor region 9 disposed on the second side wall S2, and the fourth P-type semiconductor region 5 is disposed on the side that is of the third P-type semiconductor region 9 and that is away from the second side wall S2 of the first trench 71. The source 13 is connected to the second P-type semiconductor region 8 sequentially through the fourth P-type semiconductor region 5 and the third P-type semiconductor region 9 that are disposed in correspondence with each other, so that the voltage loaded on the source 13 is input to the second P-type semiconductor region 8 sequentially through the fourth P-type semiconductor region 5 and the third P-type semiconductor region 9, the second P-type semiconductor region 8 has the voltage, the electric field of the gate dielectric layer 10 at the bottom of the trench structure 7 can be effectively shielded, and working robustness of the device is improved.

It should be noted that, according to the semiconductor device provided in this embodiment of this application, because the first side wall S 1 and the second side wall S2 of the trench structure 7 each are disposed with the third P-type semiconductor region 9, the first P-type semiconductor region 4 (that is, the first P-type semiconductor region 4 below the fourth P-type semiconductor region 5) disposed on the first side wall S1 and the second side wall S2 of the trench structure 7 is not controlled by the gate 11 and does not have performance of a channel. Therefore, in the second direction y, a part that is of a side wall of the trench structure 7 and that corresponds to the gate 11 is a channel.

For example, refer to FIG. 8 to FIG. 10. In the semiconductor device provided in this embodiment of this application, a plurality of source regions 6 may also be disposed. A plurality of source regions 6 and a plurality of fourth P-type semiconductor regions 5 that are located at a same end of the trench structure 7 are alternately disposed. For example, a plurality of source regions 6 and a plurality of fourth P-type semiconductor regions 5 that are located on first side walls S1 of a plurality of first trenches 71 in a same trench structure 7 are alternately disposed. In addition, a plurality of source regions 6 and a plurality of fourth P-type semiconductor regions 5 that are located on second side walls S2 of a plurality of first trenches 71 in a same trench structure 7 are alternately disposed.

Specifically, a width of the fourth P-type semiconductor region 5 in the second direction y is not limited in this application. For example, the width of the fourth P-type semiconductor region 5 in the second direction y may be the same as or similar to a width of the first trench 71. Correspondingly, a width of the source region 6 in the second direction y is the same as or similar to the trench spacing C between two adjacent first trenches 71. Certainly, the width of the fourth P-type semiconductor region 5 in the second direction y may alternatively be different from the width of the first trench 71. This is not limited herein.

In some embodiments of this application, refer to FIG. 3 to FIG. 10. A projection of the second P-type semiconductor region 8 in the third direction z may cover the trench structure 7 and the third P-type semiconductor region 9. In other words, an orthographic projection of the second P-type semiconductor region 8 on the semiconductor substrate 1 not only covers an orthographic projection of the trench structure 7 on the semiconductor substrate 1, but also covers orthographic projection of all the third P-type semiconductor regions 9 on the semiconductor substrate 1.

In some embodiments of this application, refer to FIG. 3 to FIG. 10. The second P-type semiconductor region 8 may be a planar region extending in the second direction y. In addition, a shape of the second P-type semiconductor region 8 is not limited in this application. For example, the shape of the second P-type semiconductor region 8 may be set to a rectangle.

In some embodiments of this application, refer to FIG. 3 to FIG. 10. The projection of the second P-type semiconductor region 8 in the third direction z may further cover a gap between two adjacent first trenches 71. For example, the projection of the second P-type semiconductor region 8 in the third direction z may further cover a gap between two adjacent first trenches 71 in the second direction y. In other words, the orthographic projection of the second P-type semiconductor region 8 on the semiconductor substrate 1 further covers an orthographic projection, on the semiconductor substrate 1, of the gap between the two adjacent first trenches 71 in the second direction y.

In some embodiments of this application, refer to FIG. 3 to FIG. 10. Usually, one second P-type semiconductor region 8 is disposed in correspondence with one trench structure 7. In other words, if one trench structure 7 is disposed, one second P-type semiconductor region 8 that is a planar region is correspondingly disposed. If two trench structures 7 are disposed, two second P-type semiconductor regions 8 that are planar regions are correspondingly disposed. In addition, there is a gap between the two second P-type semiconductor regions 8. If a plurality of trench structures 7 are disposed, a plurality of second P-type semiconductor regions 8 that are planar regions are correspondingly disposed. In addition, there is a gap between every two adjacent second P-type semiconductor regions 8.

Specifically, refer to FIG. 3 and FIG. 9. In the second direction y, there is the trench spacing C between two adjacent first trenches 71. A specific value of the trench spacing C is not limited in this application. For example, the trench spacing C may be less than 1 µm. Optionally, a range of the trench spacing C is 50 nm to 0.5 µm. It should be noted that, when the trench spacing C is less than 100 nm, the semiconductor device provided in this application forms a fin field effect transistor (Fin Field-Effect Transistor, Fin FET) effect, so that channel carrier mobility can be significantly improved, and the total on-resistance of the device can be further reduced.

Specifically, still refer to FIG. 3, FIG. 4, and FIG. 9. In the first direction, the first trench 71 has a trench length D. The trench length D is not limited in this application. For example, the trench length D may be greater than 5 µm.

Specifically, still refer to FIG. 3. In the second direction y, the first trench 71 has a trench width E. The trench width E is not limited in this application. For example, the trench width E may be less than 1 µm.

Specifically, still refer to FIG. 3. In the first direction x, the contact hole 121 has a contact width F, so that the trench spacing C is not greater than the contact width F. Certainly, the trench spacing C may alternatively be greater than the contact width F. In actual application, the trench spacing C and the contact width F may be determined based on an actual application environment requirement. This is not limited herein.

In the semiconductor device provided in this embodiment of this application, the first P-type semiconductor regions 4 on the two side walls that are of the first trench 71 in the trench structure 7 and that are in the second direction y form channel regions of the SiC MOSFET. Therefore, the trench width D is increased or the trench spacing C is reduced, so that a density of a conductive channel of the SiC MOSFET device can be increased, and the total on-resistance of the SiC MOSFET device can be reduced.

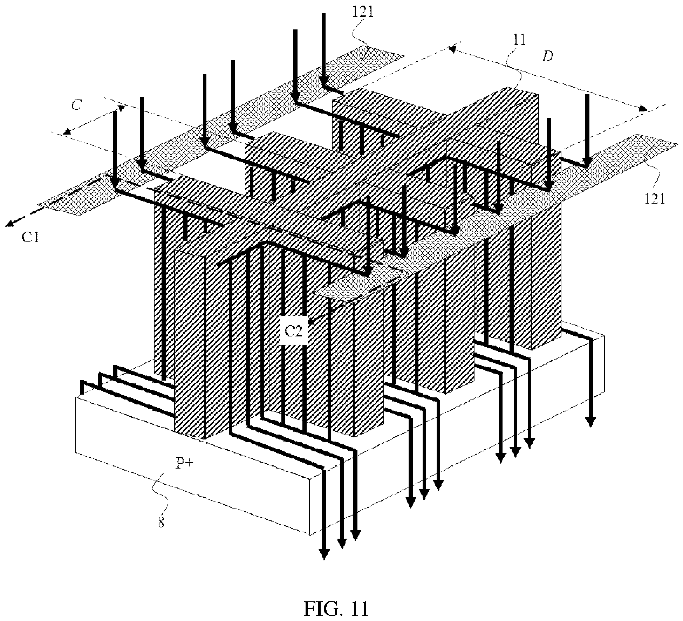

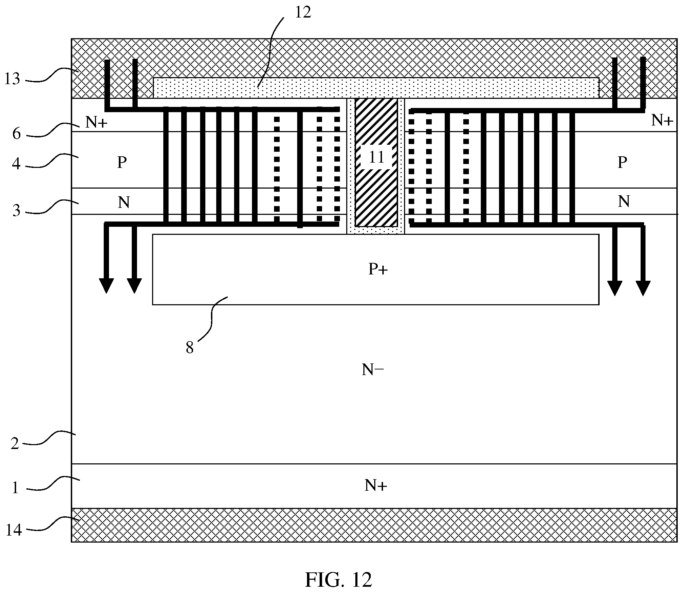

FIG. 11 shows some schematic diagrams when a semiconductor device according to an embodiment of this application generates a conduction current. FIG. 12 shows a schematic diagram of a sectional-view structure in a tangential direction of C1C2 in FIG. 11. Refer to FIG. 11 and FIG. 12. A black straight line with an arrow represents a flow direction of a conduction current when a SiC MOSFET is turned on. For example, when a voltage of a positive level is loaded on a gate 11 of the SiC MOSFET, the MOSFET that is of a trench structure 7 and that is provided in this application may be controlled to be turned on. In this case, if different voltages are loaded on a source 13 and a drain 14 (for example, a voltage loaded on the source 13 is greater than a voltage loaded on the drain 14), the conduction current that flows from the source 13 to the drain 14 and that is shown in FIG. 11 and FIG. 12 is generated between the source 13 and the drain 14.

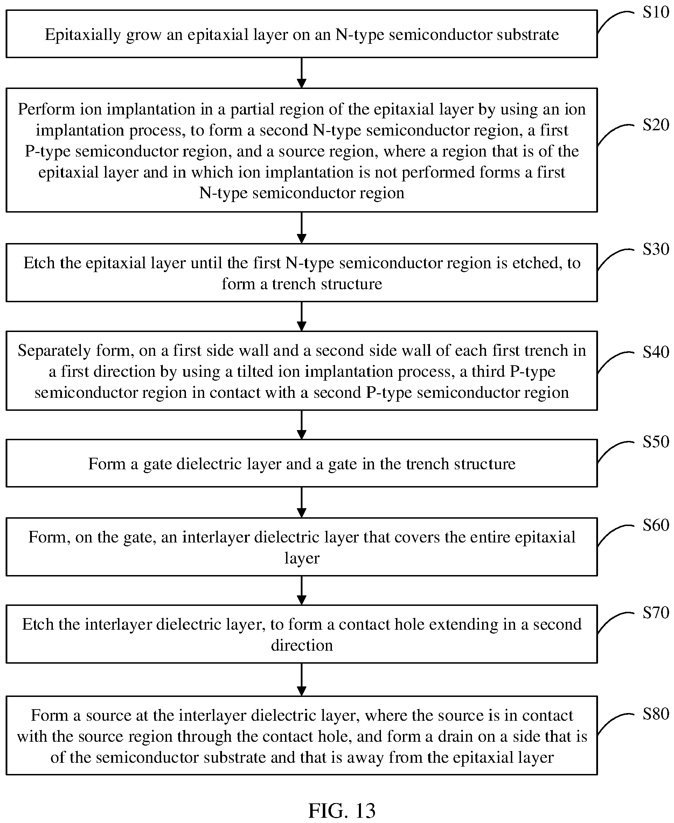

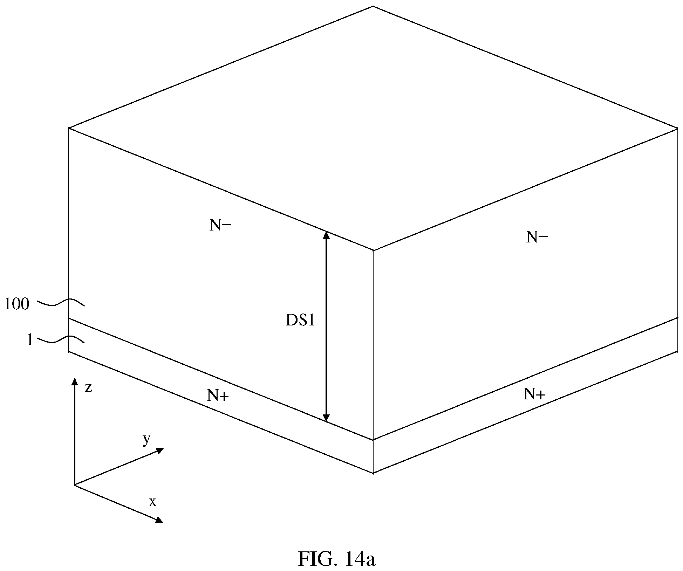

FIG. 13 shows some flowcharts of a manufacturing method for a semiconductor device according to an embodiment of this application. FIG. 14a to FIG. 14j each show a schematic structural diagram of a manufacturing process of a semiconductor device according to an embodiment of this application. Refer to FIG. 13. For example, the structure shown in FIG. 8 is manufactured, and the manufacturing method may include the following steps.

S10: Epitaxially grow an epitaxial layer on an N-type semiconductor substrate.

For example, step S10 includes:
First, refer to FIG. 14a. An epitaxial layer 100 that reaches a first specified thickness DS 1 (that is, a thickness in a third direction z) is epitaxially grown on an N-type SiC semiconductor substrate 1.

For example, a SiC material doped with an N-type impurity is epitaxially grown on the N-type SiC semiconductor substrate 1 by using an epitaxial growth process, to form the epitaxial layer 100 that reaches the first specified thickness DS1.

A specific value of the first specified thickness DS1 is not limited in this application. In actual application, the specific value of the first specified thickness DS1 may be determined based on a requirement of an actual application environment.

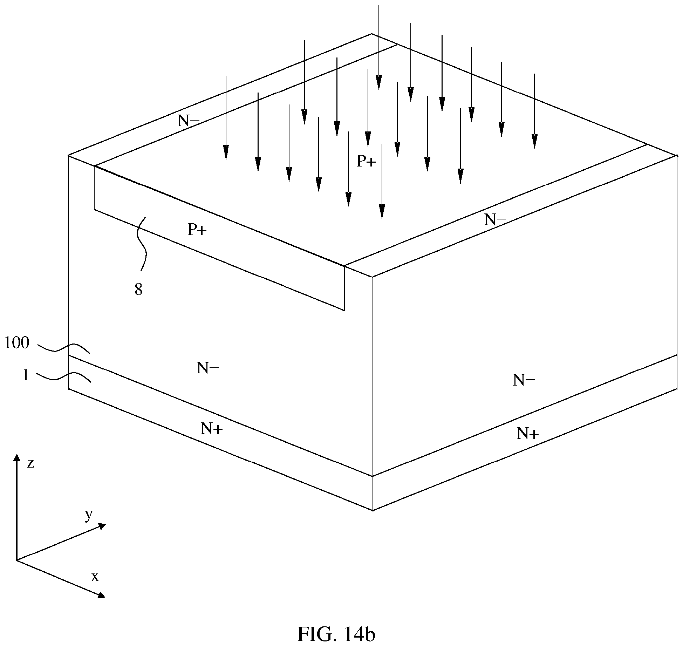

Then, refer to FIG. 14b. Ion implantation is performed at the epitaxial layer 100 by using an ion implantation process, to form a second P-type semiconductor region 8.

For example, a P-type impurity is doped, by using the ion implantation process, in the to-be-formed second P-type semiconductor region 8 at the epitaxial layer 100, to form the second P-type semiconductor region 8 that is a planar region.

A thickness of the second P-type semiconductor region 8 (that is, a thickness in the third direction) is not limited in this application. In actual application, a specific value of the thickness of the second P-type semiconductor region 8 may be determined based on a requirement of an actual application environment.

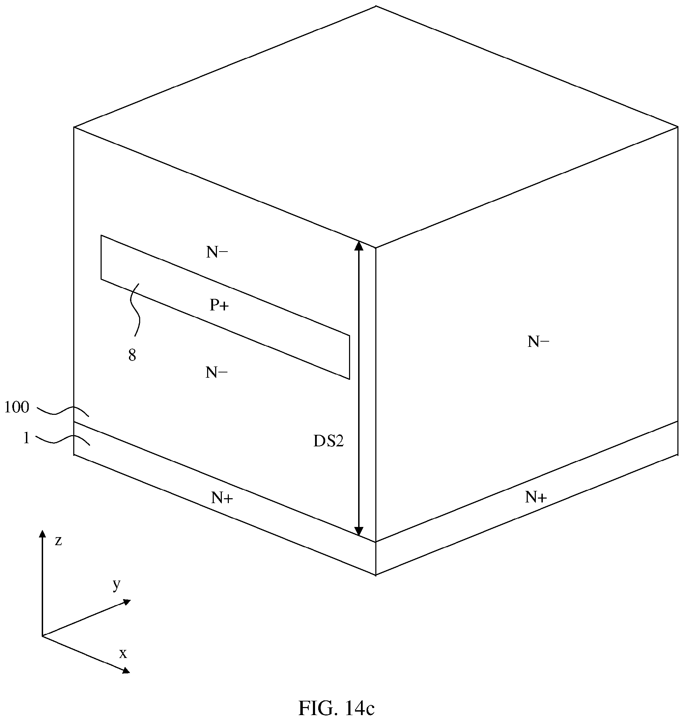

Then, refer to FIG. 14c. Epitaxial growth is continued at the epitaxial layer 100 at which the second P-type semiconductor region 8 is formed, until an epitaxial layer 100 that reaches a second specified thickness DS2 is formed.

For example, the SiC material doped with the N-type impurity continues to be epitaxially grown, by using the epitaxial growth process, at the epitaxial layer 100 at which the second P-type semiconductor region 8 is formed, to form the epitaxial layer 100 that reaches the second specified thickness DS2.

S20: Perform ion implantation in a partial region of the epitaxial layer by using the ion implantation process, to form a second N-type semiconductor region, a first P-type semiconductor region, and a source region, where a region that is of the epitaxial layer and in which ion implantation is not performed forms a first N-type semiconductor region.

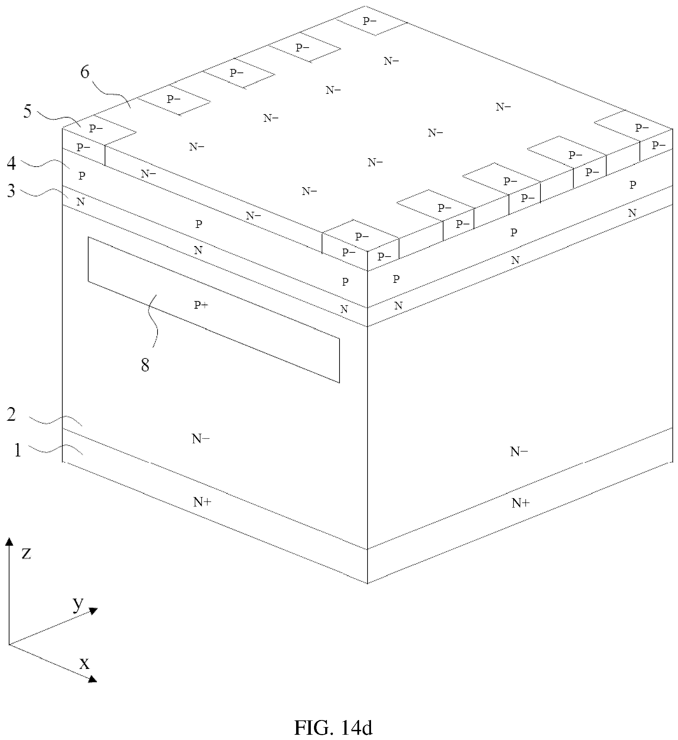

For example, refer to FIG. 14d. The N-type impurity is doped on a surface of the epitaxial layer 100 by using the ion implantation process, to form a second N-type semiconductor region 3. Then, the P-type impurity is doped on the surface of the epitaxial layer by using the ion implantation process, to form a first P-type semiconductor region 4. Then, the N-type impurity is doped on the surface of the epitaxial layer 100 by using the ion implantation process, to form a source region 6, and the P-type impurity is doped on a surface of the epitaxial layer 100 that is on a first side wall S1 and a second side wall S2 of the first trench 71, to form a fourth P-type semiconductor region 5 disposed at a same layer as the source region 6.

Therefore, in this embodiment of this application, after the ion implantation process is performed, a partial region of the epitaxial layer 100 forms the second N-type semiconductor region 3, the first P-type semiconductor region 4, the source region 6, and the fourth P-type semiconductor region 5, and a region that is of the epitaxial layer 100 and in which ion implantation is not performed by using the ion implantation process forms a first N-type semiconductor region 2.

S30: Etch the epitaxial layer until the first N-type semiconductor region is etched, to form a trench structure.

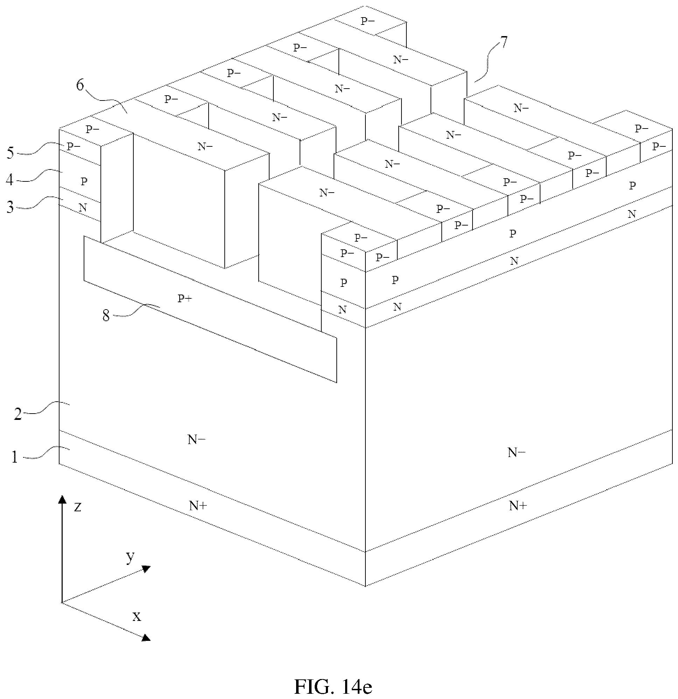

For example, first, a trench mask is formed at the epitaxial layer (where the trench mask may be a mask formed by using photoresist or a hard mask plate). A region that is of the epitaxial layer and that does not need to form the trench structure 7 is covered with the trench mask, and a region that is of the epitaxial layer and that needs to form the trench structure 7 is exposed. Then, refer to FIG. 14e. An appropriate etching process is selected from a plasma etching process, an ion sputtering etching process, a reactive ion etching process, and the like, to etch the region that is of the epitaxial layer and that is not covered with the trench mask, and stop etching when the first N-type semiconductor region 2 is etched and the second P-type semiconductor region 8 is exposed, to form, at the epitaxial layer, the trench structure 7 including a plurality of first trenches and a second trench.

S40: Separately form, on a first side wall and a second side wall of each first trench in a first direction by using a tilted ion implantation process, a third P-type semiconductor region in contact with a second P-type semiconductor region.

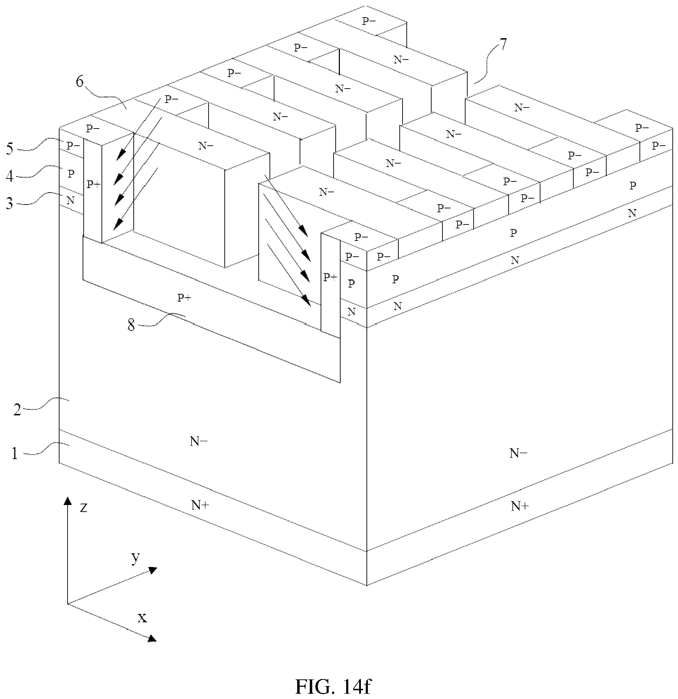

For example, refer to FIG. 14f. The P-type impurity is doped on surfaces of the first side wall S1 and the second side wall S2 of each first trench 71 by using the tilted ion implantation process, to separately form a third P-type semiconductor region 9 in contact with the second P-type semiconductor region 8.

S50: Form a gate dielectric layer and a gate in the trench structure.

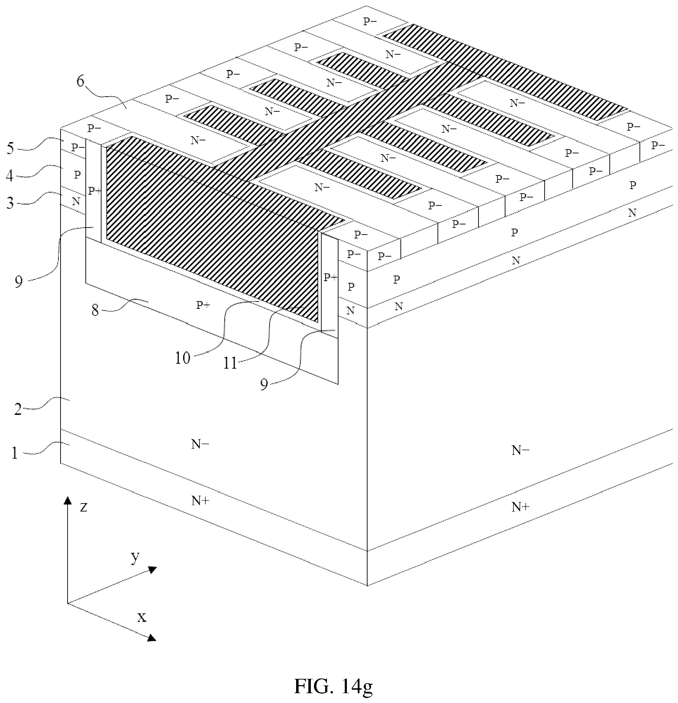

For example, refer to FIG. 14g. First, oxidation processing is performed on a surface of the trench structure 7 by using an oxidation process, so that a gate dielectric layer 10 is formed on the surface of the trench structure 7.

Then, a polycrystalline silicon material is deposited, by using a deposition process, at the entire epitaxial layer at which the trench structure is formed, so that the polycrystalline silicon material is filled in the trench structure, and the entire epitaxial layer is covered with a polycrystalline silicon material film layer after the trench structure is filled with the polycrystalline silicon material. Then, an appropriate etching process is selected from a plasma etching process, an ion sputtering etching process, a reactive ion etching process, and the like, to etch a polycrystalline silicon material region, and stop etching when the source region 6 and the fourth P-type semiconductor region 5 are exposed, to form a gate 11.

S60: Form, on the gate, an interlayer dielectric layer that covers the entire epitaxial layer.

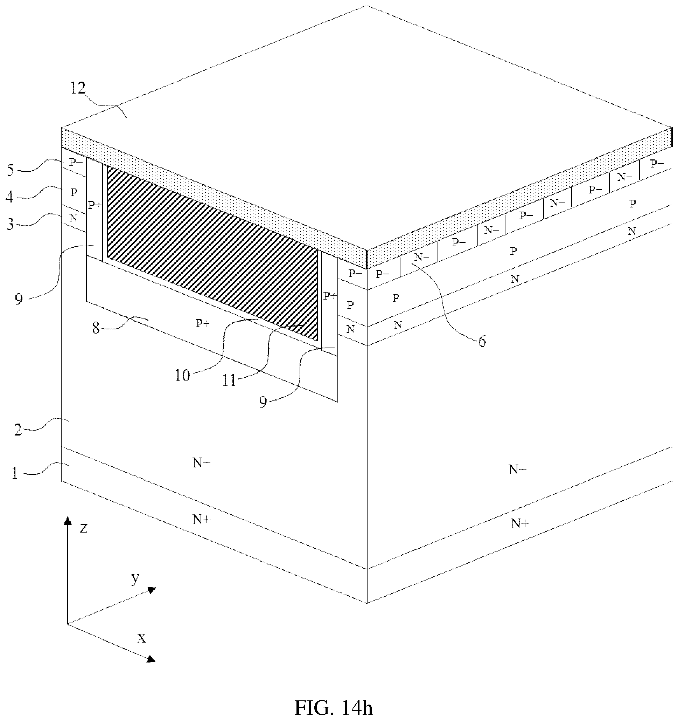

For example, refer to FIG. 14h. An interlayer dielectric layer 12 is deposited at the entire epitaxial layer by using the deposition process, and the interlayer dielectric layer 12 covers the entire epitaxial layer.

S70: Etch the interlayer dielectric layer, to form a contact hole extending in a second direction.

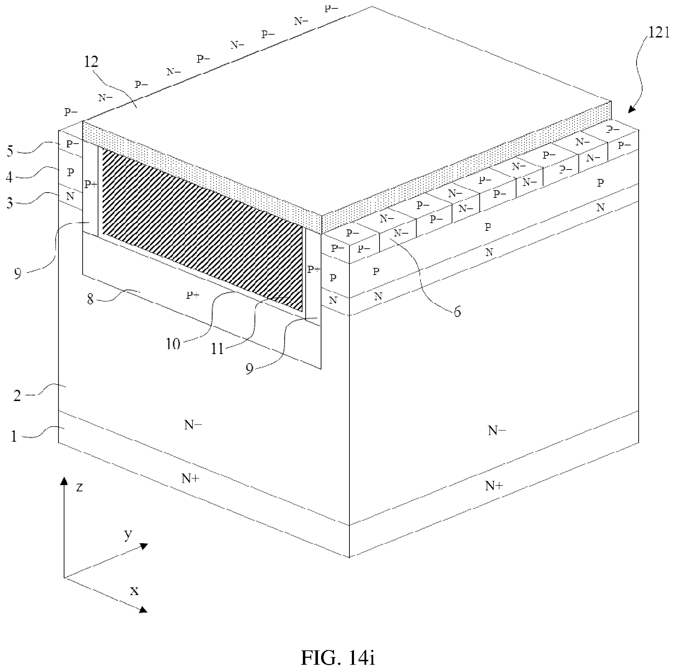

For example, first, a mask of the contact hole is formed at the epitaxial layer (where the mask of the contact hole may be a mask formed by using photoresist or a hard mask plate). A region that does not need to form a contact hole 121 is covered with the mask of the contact hole, and a region that needs to form the contact hole 121 is exposed. Then, refer to FIG. 14i. An appropriate etching process is selected from a plasma etching process, an ion sputtering etching process, a reactive ion etching process, and the like, to etch the region that is of the interlayer dielectric layer 12 and that is not covered with the mask of the contact hole 121, expose parts of the source region 6 that are in a first direction x and that are located on two sides of the gate 11, and expose parts of the fourth P-type semiconductor region 5 that are located on the two sides of the gate 11.

S80: Form a source at the interlayer dielectric layer, where the source is in contact with the source region through the contact hole, and form a drain on a side that is of the semiconductor substrate and that is away from the epitaxial layer.

A material of the source and the drain is not limited in this application. For example, the material for forming the source and the drain may be a metal material. For example, the metal material may include W, Al, Ti, Cu, Mo, or Pt.

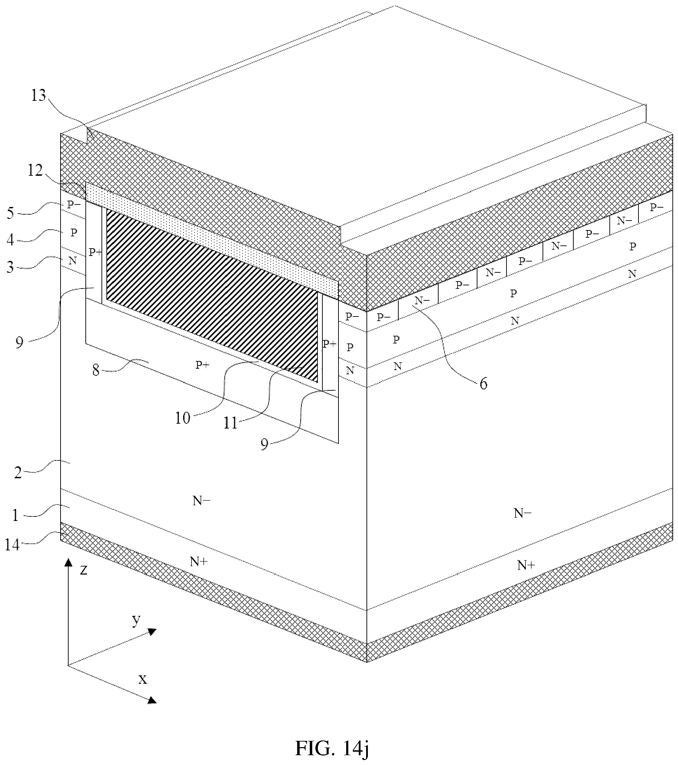

For example, refer to FIG. 14j. The metal material is deposited at the interlayer dielectric layer 12 by using the deposition process, to form a source 13. The contact hole is filled with the metal material, so that the source 13 is in contact with the source region 6 by using the metal material filled in the contact hole 121.

For example, refer to FIG. 14j. Before the source 13 is formed, the metal material may be deposited, by using the deposition process, on a side that is of the semiconductor substrate 1 and that is away from the epitaxial layer, to form a drain 14. Alternatively, after the source 13 is formed, the metal material may be deposited, by using the deposition process, on a side that is of the semiconductor substrate 1 and that is away from the epitaxial layer, to form the drain 14.

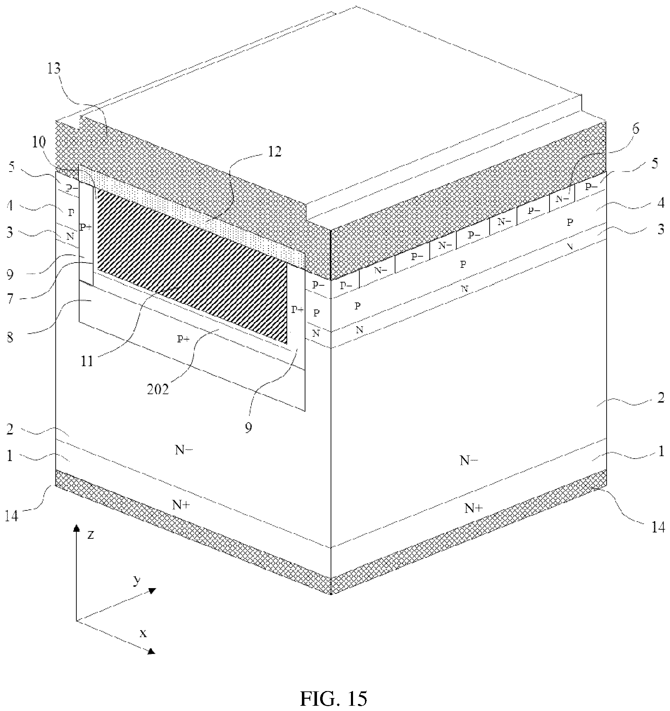

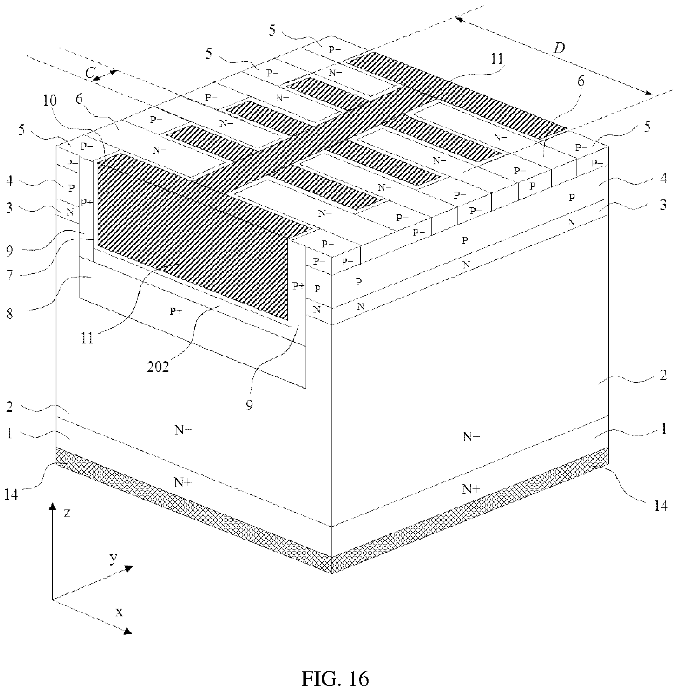

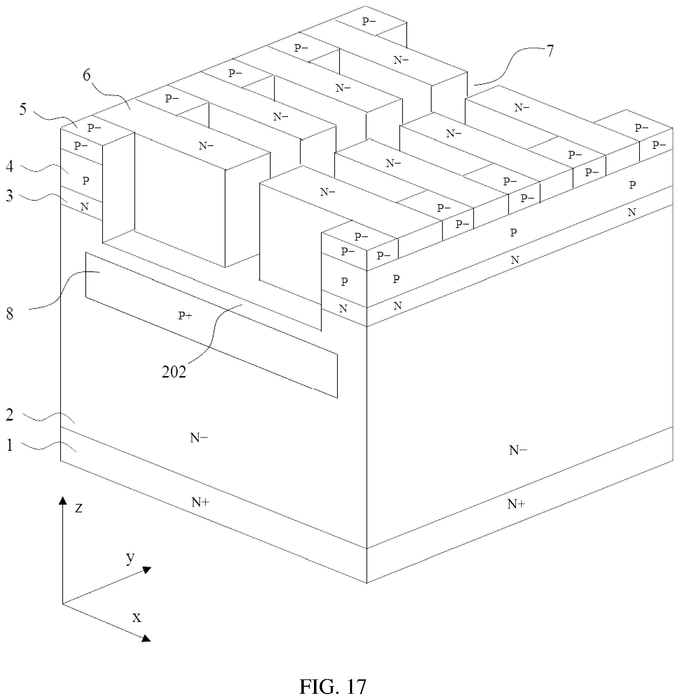

FIG. 15 shows a schematic diagram of a three-dimensional structure of a semiconductor device according to another embodiment of this application. FIG. 16 shows a schematic diagram of a three-dimensional structure existing when the semiconductor device shown in FIG. 15 is not provided with an interlayer dielectric layer or a source. FIG. 17 shows a schematic diagram of a structure of a trench structure in the semiconductor device shown in FIG. 15.

Refer to FIG. 15 to FIG. 17. In some other embodiments provided in this application, the semiconductor device may include an N-type semiconductor substrate 1, an epitaxial layer, a trench structure 7, a gate 11, an interlayer dielectric layer 12, a source 13, and a drain 14. In addition, the epitaxial layer may include a first N-type semiconductor region 2, a second N-type semiconductor region 3, a first P-type semiconductor region 4, a source region 6, a second P-type semiconductor region 8, a third P-type semiconductor region 9, and a fourth P-type semiconductor region 5. This embodiment is a variant of the implementations in the foregoing embodiment. The following describes only differences between this embodiment and the foregoing embodiment, and the same parts are not described herein again.

Refer to FIG. 15 to FIG. 17. In this embodiment, there is a spacing region 202 between the second P-type semiconductor region 8 and a bottom of the trench structure 7. In other words, the second P-type semiconductor region 8 at the bottom of the trench structure 7 is not directly in contact with the bottom of the trench structure 7, but is connected to the bottom of the trench structure 7 through the spacing region 202. For example, the spacing region 202 may be an N-type semiconductor region, and a doping concentration of the spacing region 202 is the same as or similar to a doping concentration of the first N-type semiconductor region 2. Optionally, the spacing region 202 may be a part of the first N-type semiconductor region 2.

In this embodiment of this application, the spacing region 202 may be a flow path of a conduction current of a SiC MOSFET device, so that an area of a through-current region of the SiC MOSFET device can be increased, and total on-resistance of the SiC MOSFET device can be further reduced.

For example, the structure shown in FIG. 15 is manufactured. For a flowchart of a corresponding manufacturing method, refer to FIG. 13. For steps S10 to S20 and S40 to S80, refer to the description of the foregoing manufacturing method.

In this embodiment, step S30 of etching the epitaxial layer until the first N-type semiconductor region is etched, to form the trench structure may be specifically implemented in the following manner.

In some examples, first, a trench mask is formed at the epitaxial layer (where the trench mask may be a mask formed by using photoresist or a hard mask plate). A region that is of the epitaxial layer and that forms the trench structure is covered with the trench mask, and a region that is of the epitaxial layer and that needs to form the trench structure is exposed. Then, refer to FIG. 17. An appropriate etching process is selected from a plasma etching process, an ion sputtering etching process, a reactive ion etching process, and the like, to etch the region that is of the epitaxial layer and that is not covered with the trench mask until the first N-type semiconductor region 2 is etched, and stop etching when the second P-type semiconductor region 8 is not exposed, so that a part that is of the first N-type semiconductor region 2 and that is reserved above the second P-type semiconductor region 8 forms the spacing region 202.

In some other examples, first, a trench mask is formed at the epitaxial layer (where the trench mask may be a mask formed by using photoresist or a hard mask plate). A region that is of the epitaxial layer and that forms the trench structure is covered with the trench mask, and a region that is of the epitaxial layer and that needs to form the trench structure is exposed. Then, refer to FIG. 17. An appropriate etching process is selected from a plasma etching process, an ion sputtering etching process, a reactive ion etching process, and the like, to etch the region that is of the epitaxial layer and that is not covered with the trench mask until the first N-type semiconductor region 2 is etched. According to an original design, the etching process is stopped when the second P-type semiconductor region 8 is exposed. However, due to precision limitation of the etching process, etching may be stopped when the second P-type semiconductor region 8 is not exposed. As a result, a part of the first N-type semiconductor region 2 is reserved above the second P-type semiconductor region 8, and the reserved first N-type semiconductor region 2 forms the spacing region 202.

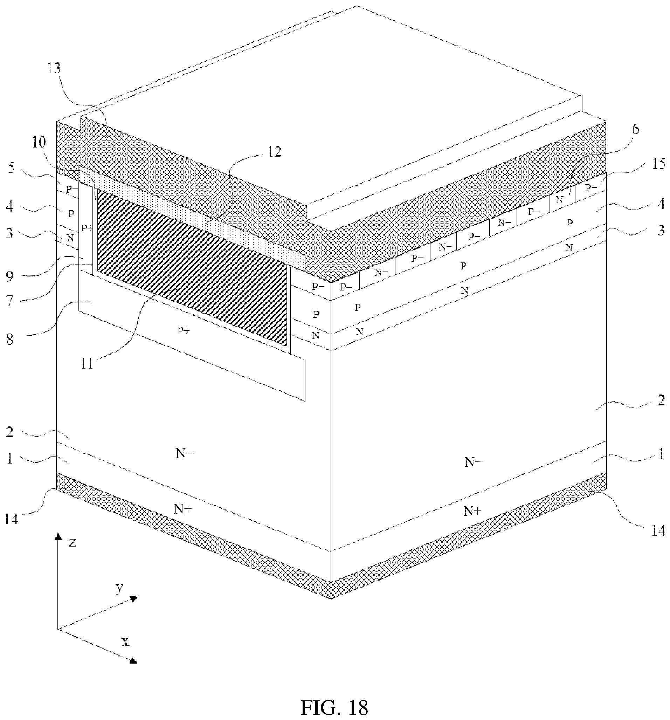

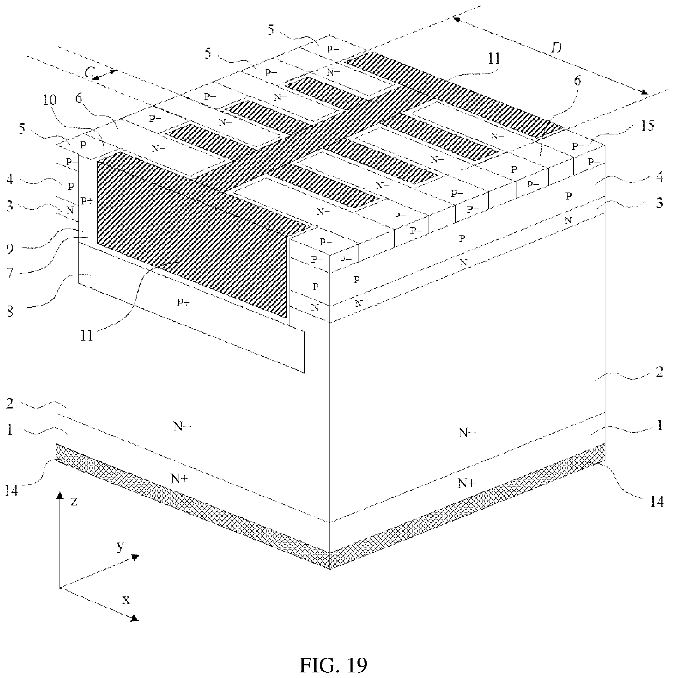

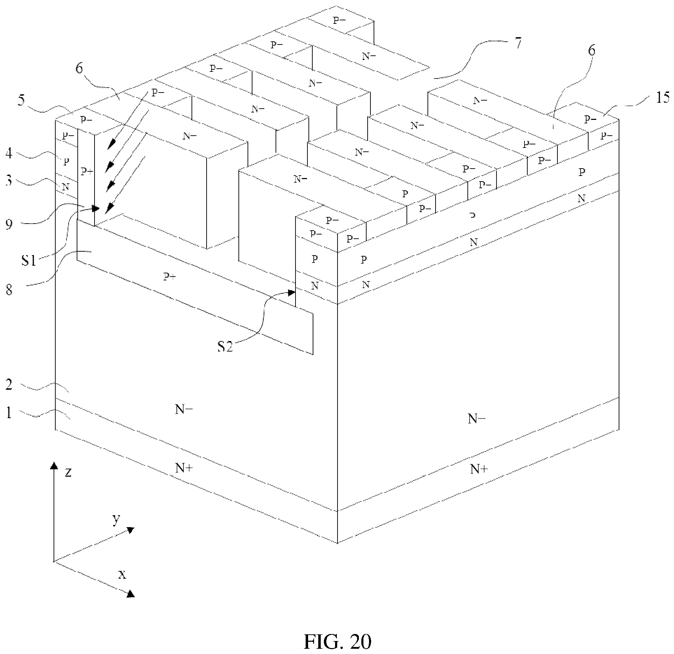

FIG. 18 shows a schematic diagram of a three-dimensional structure of a semiconductor device according to still another embodiment of this application. FIG. 19 shows a schematic diagram of a three-dimensional structure existing when the semiconductor device shown in FIG. 18 is not provided with an interlayer dielectric layer or a source. FIG. 20 shows a schematic diagram of a three-dimensional structure of a trench structure in the semiconductor device shown in FIG. 18.

Refer to FIG. 18 to FIG. 20. In still some other embodiments provided in this application, the semiconductor device provided in this embodiment of this application may specifically include an N-type semiconductor substrate 1, an epitaxial layer, a trench structure 7, a gate 11, an interlayer dielectric layer 12, a source 13, and a drain 14. In addition, the epitaxial layer may include a first N-type semiconductor region 2, a second N-type semiconductor region 3, a first P-type semiconductor region 4, a source region 6, a second P-type semiconductor region 8, third P-type semiconductor regions 9, and fourth P-type semiconductor regions 5. This embodiment is a variant of the implementations in the foregoing embodiment. The following describes only differences between this embodiment and the foregoing embodiment, and the same parts are not described herein again.

Refer to FIG. 18 to FIG. 20. In this embodiment, a plurality of third P-type semiconductor regions 9 are disposed. A first side wall S1 of each first trench 71 is disposed with one of the plurality of third P-type semiconductor regions 9, and a second side wall S2 of each first trench 71 is not disposed with a third P-type semiconductor region 9. In other words, only the first side wall S1 of each first trench 71 is disposed with the third P-type semiconductor region 9. In addition, each of the third P-type semiconductor regions 9 is in contact with the second P-type semiconductor region 8, so that each of the third P-type semiconductor regions 9 is connected to the second P-type semiconductor region 8 to perform signal transmission, and a voltage of each of the third P-type semiconductor regions 9 is the same as a voltage of the second P-type semiconductor region 8. In this embodiment of this application, positions of the first side wall S1 and the second side wall S2 of the first trench 71 may also be interchanged. To be specific, the second side wall S2 of the first trench 71 is disposed with one of the plurality of third P-type semiconductor regions 9, and the first side wall S1 of each first trench 71 is not disposed with a third P-type semiconductor region 9.

Correspondingly, refer to FIG. 18 to FIG. 20. A plurality of fourth P-type semiconductor regions 5 are also disposed, and the plurality of fourth P-type semiconductor regions 5 are disposed in a one-to-one correspondence and in contact with the plurality of third P-type semiconductor regions 9. One of the plurality of fourth P-type semiconductor regions 5 is disposed in correspondence with the third P-type semiconductor region 9 disposed on the first side wall S1, and the fourth P-type semiconductor region 5 is disposed on a side that is of the third P-type semiconductor region 9 and that is away from the first side wall S1 of the first trench 71. The source 13 is connected to the second P-type semiconductor region 8 sequentially through the fourth P-type semiconductor region 5 and the third P-type semiconductor region 9 that are disposed in correspondence with each other, so that a voltage loaded on the source 13 is input to the second P-type semiconductor region 8 sequentially through the fourth P-type semiconductor region 5 and the third P-type semiconductor region 9, the second P-type semiconductor region 8 has a voltage, an electric field of a gate dielectric layer 10 at a bottom of the trench structure 7 can be effectively shielded, and working robustness of the device is improved.

For example, refer to FIG. 18 to FIG. 20. The epitaxial layer 100 may further include a fifth P-type semiconductor region 15. The fifth P-type semiconductor region 15 and the source region 6 are disposed at a same layer. The fifth P-type semiconductor region 15 is disposed on a side that is of the second side wall S2 of the first trench 71 and that is away from the first side wall S1, and the fifth P-type semiconductor region 15 is in contact with the source 13 through a contact hole 121.

For example, a plurality of fifth P-type semiconductor regions 15 may be disposed, and the plurality of fifth P-type semiconductor regions 15 are disposed in a one-to-one correspondence with the second side walls S2 of all the first trenches 71. In addition, a plurality of source regions 6 and the plurality of fifth P-type semiconductor regions 15 that are located on second side walls S2 of the first trenches 71 are alternately disposed.

Optionally, the fifth P-type semiconductor region 15 may be formed by doping the epitaxial layer by using an ion implantation process. In addition, the fifth P-type semiconductor region 15 is mainly doped with a P-type impurity, for example, boron (B), aluminum (Al), or gallium (Ga). For example, a doping concentration of the fifth P-type semiconductor region 15 may be the same as or similar to a doping concentration of the fourth P-type semiconductor region 5.

In this embodiment of this application, the first side wall S1 of the first trench 71 is disposed with the third P-type semiconductor region 9, and no channel is formed.

For example, the structure shown in FIG. 18 is manufactured. For a flowchart of a corresponding manufacturing method, refer to FIG. 13. For steps S10 to S30 and S50 to S80, refer to the description of the foregoing manufacturing method.

In this embodiment, step S40 is as follows: Separately form, on the first side wall of each first trench in a first direction by using a tilted ion implantation process, the third P-type semiconductor region in contact with the second P-type semiconductor region.

For example, refer to FIG. 20. The P-type impurity is doped on a surface of the first side wall S1 of each first trench 71 by using the tilted ion implantation process, to separately form the third P-type semiconductor region 9 in contact with the second P-type semiconductor region 8.

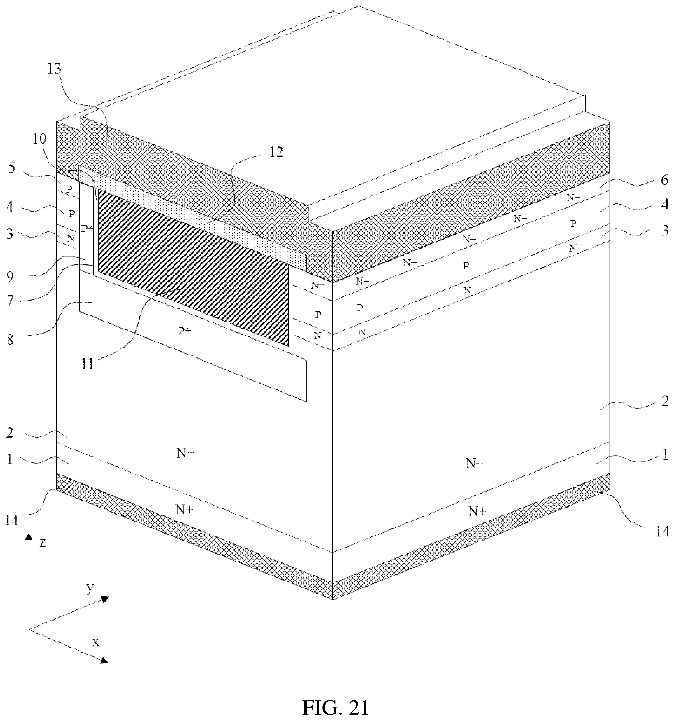

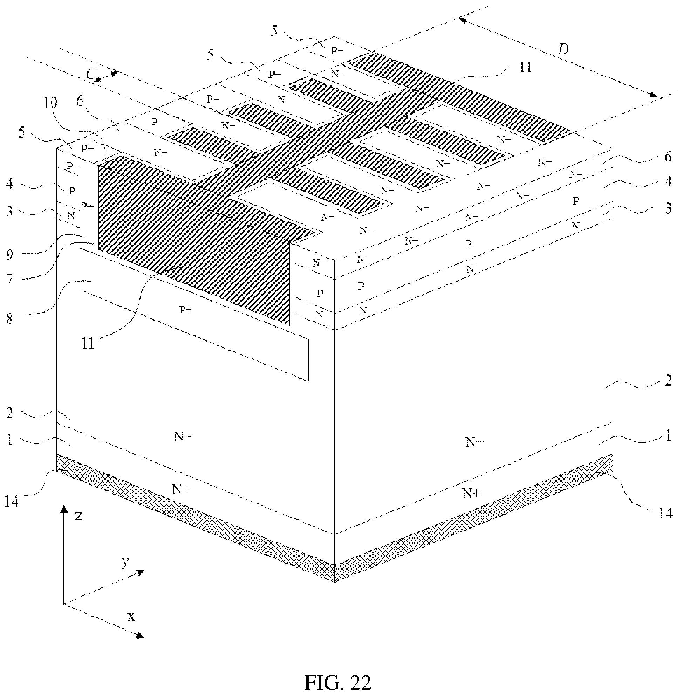

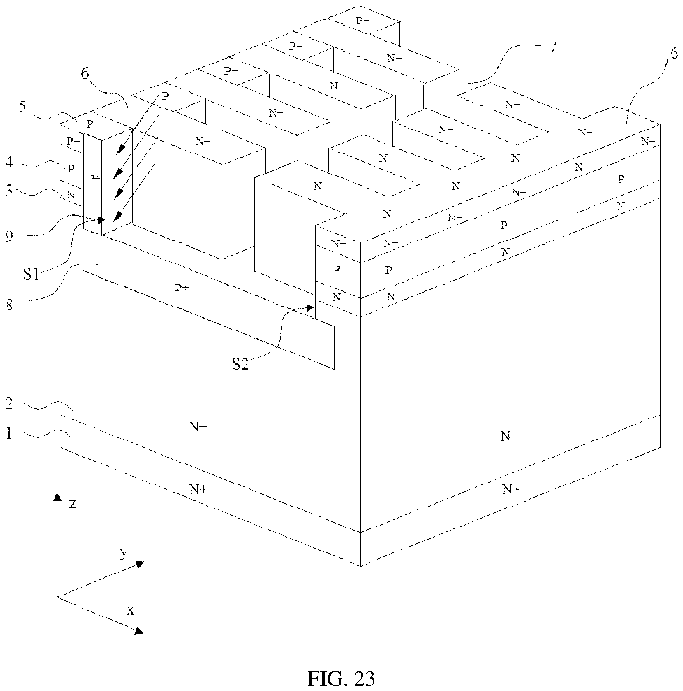

FIG. 21 shows a schematic diagram of a three-dimensional structure of a semiconductor device according to still another embodiment of this application. FIG. 22 shows a schematic diagram of a three-dimensional structure existing when the semiconductor device shown in FIG. 21 is not provided with an interlayer dielectric layer or a source. FIG. 23 shows a schematic diagram of a three-dimensional structure of a trench structure in the semiconductor device shown in FIG. 21.

Refer to FIG. 21 to FIG. 23. In still some other embodiments provided in this application, the semiconductor device may specifically include an N-type semiconductor substrate 1, an epitaxial layer, a trench structure 7, a gate 11, an interlayer dielectric layer 12, a source 13, and a drain 14. In addition, the epitaxial layer may include a first N-type semiconductor region 2, a second N-type semiconductor region 3, a first P-type semiconductor region 4, a source region 6, a second P-type semiconductor region 8, third P-type semiconductor regions 9, and fourth P-type semiconductor regions 5. This embodiment is a variant of the implementations in the foregoing embodiment. The following describes only differences between this embodiment and the foregoing embodiment, and the same parts are not described herein again.

Refer to FIG. 21 to FIG. 23. In this embodiment, a plurality of third P-type semiconductor regions 9 are disposed. A first side wall S1 of each first trench 71 is disposed with one of the plurality of third P-type semiconductor regions 9, and a second side wall S2 of each first trench 71 is not disposed with a third P-type semiconductor region 9. In other words, only the first side wall S1 of each first trench 71 is disposed with the third P-type semiconductor region 9. In addition, each of the third P-type semiconductor regions 9 is in contact with the second P-type semiconductor region 8, so that each of the third P-type semiconductor regions 9 is connected to the second P-type semiconductor region 8 to perform signal transmission, and a voltage of each of the third P-type semiconductor regions 9 is the same a voltage of the second P-type semiconductor region 8. In this embodiment of this application, positions of the first side wall S1 and the second side wall S2 of the first trench 71 may also be interchanged. To be specific, the second side wall S2 of the first trench 71 may be disposed with one of the plurality of third P-type semiconductor regions 9, and the first side wall S1 of each first trench 71 is not disposed with a third P-type semiconductor region 9.

Correspondingly, refer to FIG. 21 to FIG. 23. A plurality of fourth P-type semiconductor regions 5 are also disposed, and the plurality of fourth P-type semiconductor regions 5 are disposed in a one-to-one correspondence and in contact with the plurality of third P-type semiconductor regions 9. One of the plurality of fourth P-type semiconductor regions 5 is disposed in correspondence with the third P-type semiconductor region 9 disposed on the first side wall S1, and the fourth P-type semiconductor region 5 is disposed on a side that is of the third P-type semiconductor region 9 and that is away from the first side wall S1 of the first trench 71. The source 13 is connected to the second P-type semiconductor region 8 sequentially through the fourth P-type semiconductor region 5 and the third P-type semiconductor region 9 that are disposed in correspondence with each other, so that a voltage loaded on the source 13 is input to the second P-type semiconductor region 8 sequentially through the fourth P-type semiconductor region 5 and the third P-type semiconductor region 9, the second P-type semiconductor region 8 has a voltage, an electric field of a gate dielectric layer 10 at a bottom of the trench structure 7 can be effectively shielded, and working robustness of the device is improved.

For example, refer to FIG. 21 to FIG. 23. Only the first side wall S1 of the first trench 71 is disposed with the fourth P-type semiconductor region 5, and the second side wall S2 of the first trench 71 is disposed with only the source region 6.

For example, the structure shown in FIG. 21 is manufactured. For a flowchart of a corresponding manufacturing method, refer to FIG. 13. For steps S10, S30, and S50 to S80, refer to the description of the foregoing manufacturing method.

In this embodiment, step S20 is as follows: Perform ion implantation in a partial region of the epitaxial layer by using an ion implantation process, to form the second N-type semiconductor region, the first P-type semiconductor region, and the source region, where a region that is of the epitaxial layer and in which ion implantation is not performed forms the first N-type semiconductor region.

For example, refer to FIG. 23. An N-type impurity is doped on a surface of the epitaxial layer by using the ion implantation process, to form the second N-type semiconductor region 3. Then, a P-type impurity is doped on the surface of the epitaxial layer by using the ion implantation process, to form the first P-type semiconductor region 4. Then, the N-type impurity is doped on the surface of the epitaxial layer by using the ion implantation process, to form the source region 6, and the P-type impurity is doped on a surface of the epitaxial layer that is on the first side wall S1 of the first trench 71, to form the fourth P-type semiconductor region 5 disposed at a same layer as the source region 6. Therefore, in this embodiment of this application, after the ion implantation process is performed, the partial region of the epitaxial layer forms the second N-type semiconductor region 3, the first P-type semiconductor region 4, the source region 6, and the fourth P-type semiconductor region 5, and the region that is of the epitaxial layer and in which ion implantation is not performed by using the ion implantation process forms the first N-type semiconductor region 2.

In this embodiment, step S40 is as follows: Separately form, on the first side wall of each first trench in a first direction by using a tilted ion implantation process, the third P-type semiconductor region in contact with the second P-type semiconductor region.

For example, refer to FIG. 23. The P-type impurity is doped on a surface of the first side wall S1 of each first trench 71 by using the tilted ion implantation process, to separately form the third P-type semiconductor region 9 in contact with the second P-type semiconductor region 8.

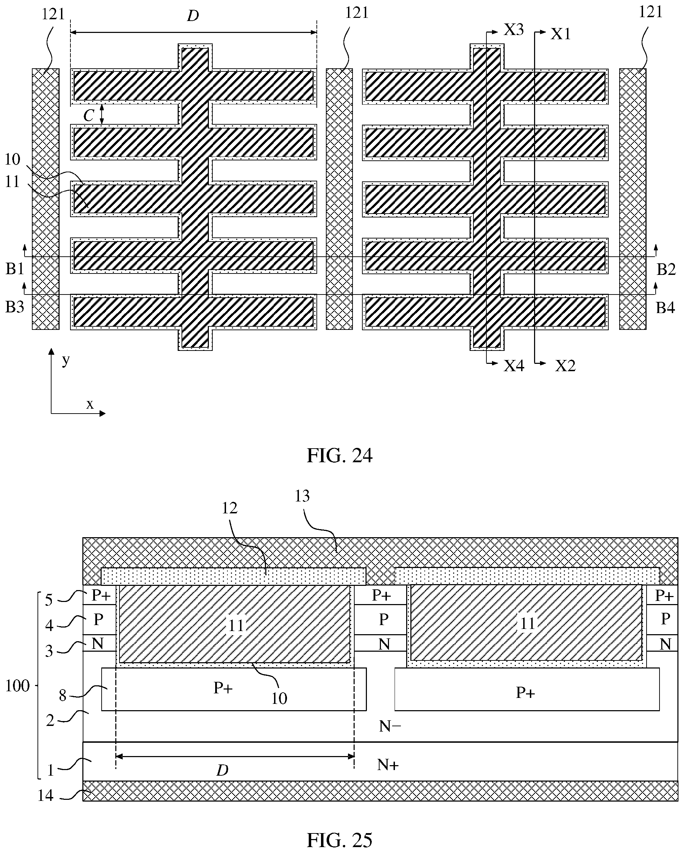

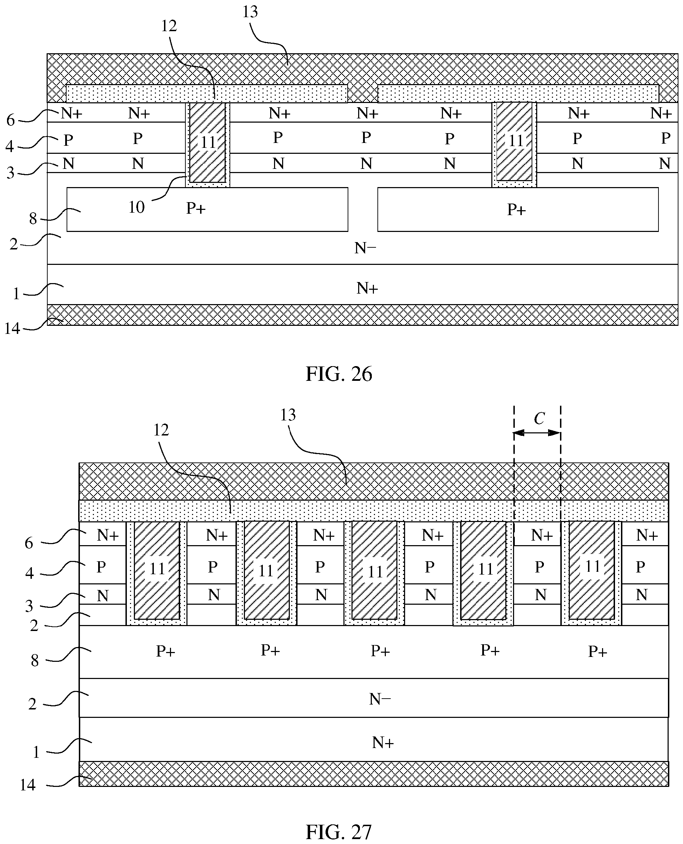

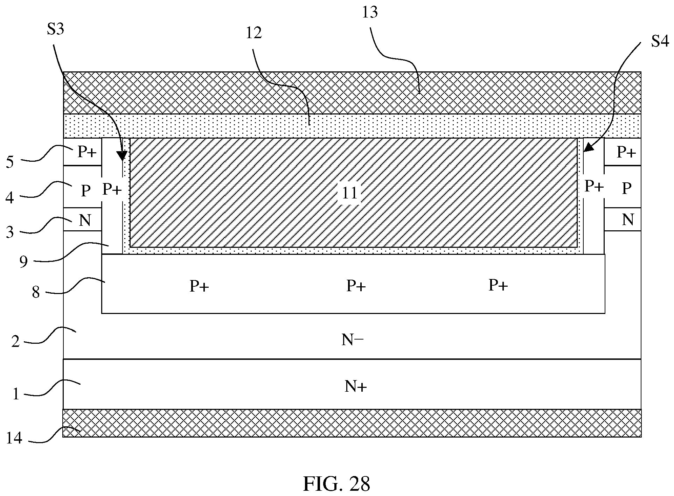

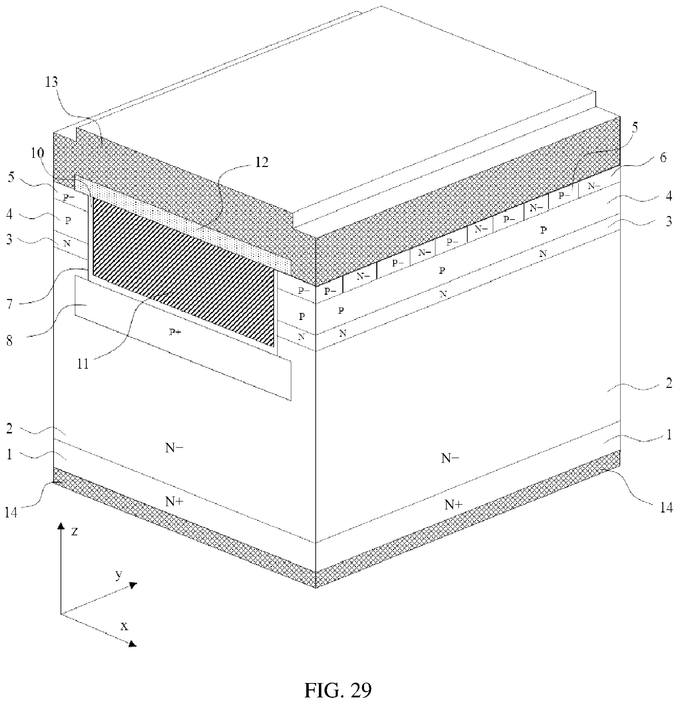

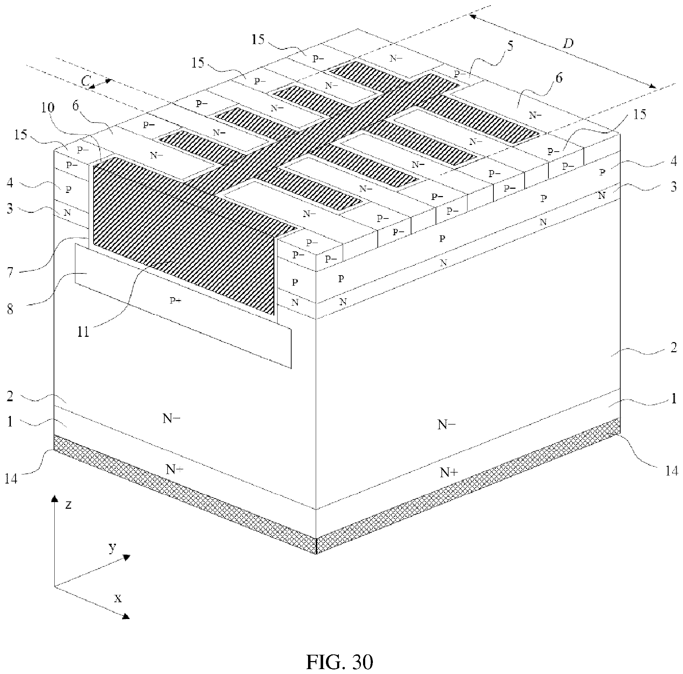

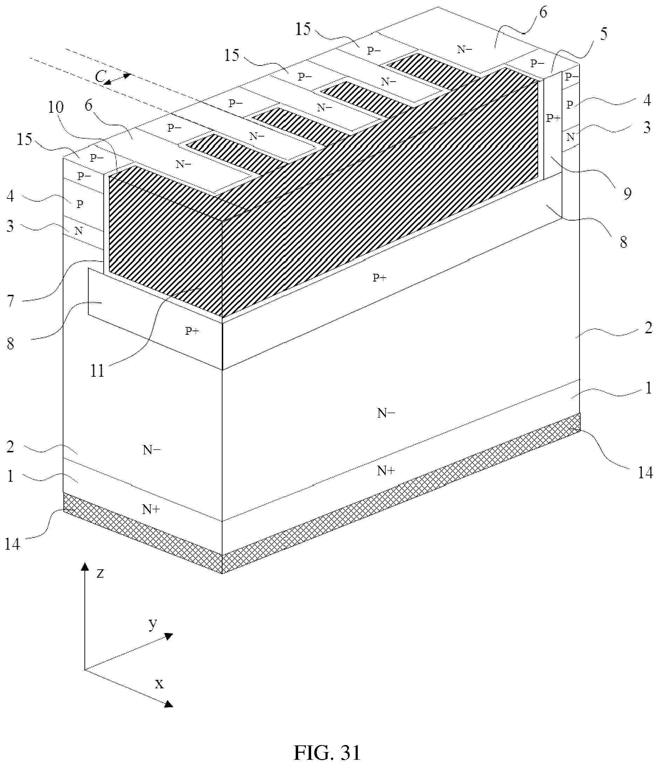

FIG. 24 shows a schematic diagram of a top-view structure of a semiconductor device according to another embodiment of this application. FIG. 25 shows a schematic diagram of a sectional-view structure in a tangential direction of B1B2 in FIG. 24. FIG. 26 shows a schematic diagram of a sectional-view structure in a tangential direction of B3B4 in FIG. 24. FIG. 27 shows a schematic diagram of a sectional-view structure in a tangential direction of X1X2 in FIG. 24. FIG. 28 shows a schematic diagram of a sectional-view structure in a tangential direction of X3X4 in FIG. 24. FIG. 29 shows a schematic diagram of a partial three-dimensional structure in FIG. 24. FIG. 30 shows a schematic diagram of a three-dimensional structure existing when the semiconductor device shown in FIG. 29 is not provided with an interlayer dielectric layer or a source. FIG. 31 shows a schematic diagram of a partial three-dimensional structure of the semiconductor device shown in FIG. 30.

Refer to FIG. 24 to FIG. 31. In still some other embodiments provided in this application, the semiconductor device provided in this embodiment of this application may specifically include an N-type semiconductor substrate 1, an epitaxial layer, a trench structure 7, a gate 11, an interlayer dielectric layer 12, a source 13, and a drain 14. In addition, the epitaxial layer may include a first N-type semiconductor region 2, a second N-type semiconductor region 3, a first P-type semiconductor region 4, a source region 6, a second P-type semiconductor region 8, third P-type semiconductor regions 9, and fourth P-type semiconductor regions 5. This embodiment is a variant of the implementations in the foregoing embodiment. The following describes only differences between this embodiment and the foregoing embodiment, and the same parts are not described herein again.

In this embodiment, at least one end part of a second trench 72 may extend out of a first trench 71 located at an edge in the plurality of first trenches 71. In a second direction y, the second trench 72 may have a third side wall S3 and a fourth side wall S4 that are disposed opposite to each other, and the third P-type semiconductor regions 9 may be disposed on the third side wall S3 and/or the fourth side wall S4 of the second trench 72. For example, refer to FIG. 24. Both end parts of the second trench 72 extend out of the first trench 71 located at the edge in the plurality of first trenches 71. Refer to FIG. 28. The third P-type semiconductor regions 9 may be disposed on the third side wall S3 and the fourth side wall S4 of the second trench 72. In other words, the third side wall S3 and the fourth side wall S4 of the second trench 72 each are disposed with the third P-type semiconductor region 9. In addition, each of the third P-type semiconductor regions 9 is in contact with the second P-type semiconductor region 8, so that each of the third P-type semiconductor regions 9 is connected to the second P-type semiconductor region 8 to perform signal transmission, and a voltage of each of the third P-type semiconductor regions 9 is the same as a voltage of the second P-type semiconductor region 8. Correspondingly, the fourth P-type semiconductor region 5 is disposed in a one-to-one correspondence and in contact with the third P-type semiconductor region 9. One fourth P-type semiconductor region 5 is disposed in correspondence with the third P-type semiconductor region 9 disposed on the third side wall S3, and the fourth P-type semiconductor region 5 is disposed on a side that is of the third P-type semiconductor region 9 and that is away from the third side wall S3 of the second trench 72. In addition, one fourth P-type semiconductor region 5 is disposed in correspondence with the third P-type semiconductor region 9 disposed on the fourth side wall S4, and the fourth P-type semiconductor region 5 is disposed on a side that is of the third P-type semiconductor region 9 and that is away from the fourth side wall S4 of the second trench 72. A voltage may be input to the second P-type semiconductor region 8 sequentially through the fourth P-type semiconductor region 5 and the third P-type semiconductor region 9, so that the second P-type semiconductor region 8 has a voltage, an electric field of a gate dielectric layer 10 at a bottom of the trench structure 7 can be effectively shielded, and working robustness of the device is improved.

For example, refer to FIG. 24 to FIG. 31. The epitaxial layer 100 may further include a fifth P-type semiconductor region 15. The fifth P-type semiconductor region 15 and the source region 6 are disposed at a same layer. The fifth P-type semiconductor region 15 may be disposed on a side that is of a second side wall S2 of the first trench 71 and that is away from a first side wall S1. The fifth P-type semiconductor region 15 may be further disposed on a side that is of the first side wall S1 of the first trench 71 and that is away from the second side wall S2, and the fifth P-type semiconductor region 15 is in contact with the source 13 through a contact hole 121.

For example, a plurality of fifth P-type semiconductor regions 15 may be disposed, and the plurality of fifth P-type semiconductor regions 15 are disposed in a one-to-one correspondence with the first side walls S1 and the second side walls S2 of all the first trenches 71. In addition, a plurality of source regions 6 and a plurality of fifth P-type semiconductor regions 15 that are located on first side walls S1 of the first trenches 71 are alternately disposed, and a plurality of source regions 6 and a plurality of fifth P-type semiconductor regions 15 that are located on second side walls S2 of the first trenches 71 are alternately disposed.

Optionally, the fifth P-type semiconductor region 15 may be formed by doping the epitaxial layer by using an ion implantation process. In addition, the fifth P-type semiconductor region 15 is mainly doped with a P-type impurity, for example, boron (B), aluminum (Al), or gallium (Ga). For example, a doping concentration of the fifth P-type semiconductor region 15 may be the same as or similar to a doping concentration of the fourth P-type semiconductor region 5.

In this embodiment of this application, the third side wall S3 and the fourth side wall S4 of the second trench 72 are disposed with the third P-type semiconductor regions 9, and no channel is formed.

For example, the structure shown in FIG. 29 is prepared. For a flowchart of a corresponding manufacturing method, refer to FIG. 13. For steps S10 to S30 and S50 to S80, refer to the description of the foregoing manufacturing method.

In this embodiment, step S40 is as follows: Separately form, on the third side wall and the fourth side wall of the second trench in the second direction by using a tilted ion implantation process and, the third P-type semiconductor region in contact with the second P-type semiconductor region.

For example, the P-type impurity may be doped on surfaces of the third side wall S3 and the fourth side wall S4 of the second trench 72 by using the tilted ion implantation process, to separately form the third P-type semiconductor region 9 in contact with the second P-type semiconductor region 8.

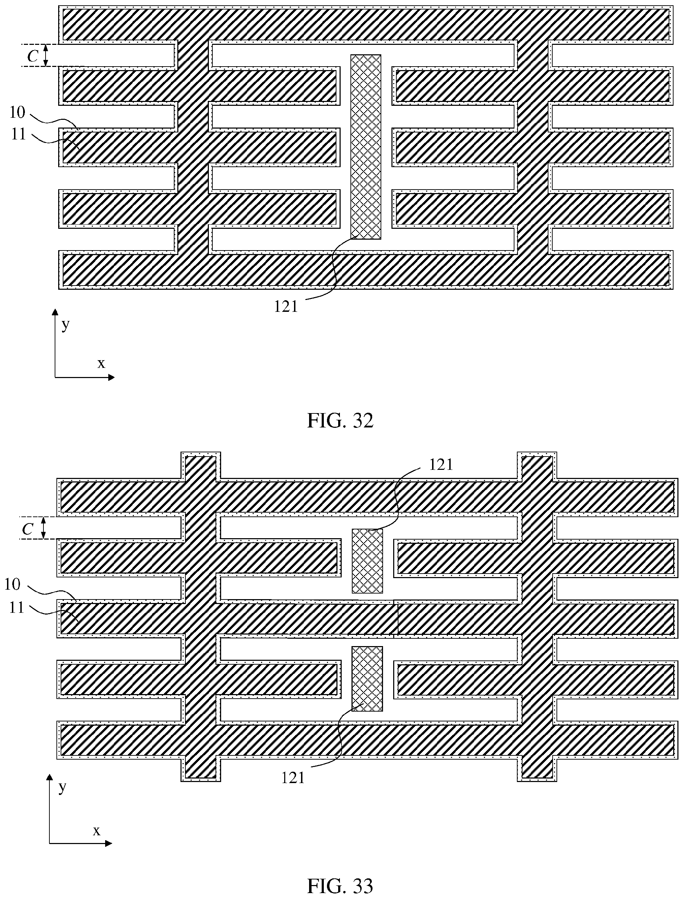

FIG. 32 shows a schematic diagram of a top-view structure of a semiconductor device according to another embodiment of this application. FIG. 33 shows a schematic diagram of a top-view structure of a semiconductor device according to still another embodiment of this application.

Refer to FIG. 32 and FIG. 33. In still some other embodiments provided in this application, the semiconductor device may specifically include an N-type semiconductor substrate 1, an epitaxial layer, a trench structure 7, a gate 11, an interlayer dielectric layer 12, a source 13, and a drain 14. In addition, the epitaxial layer may include a first N-type semiconductor region 2, a second N-type semiconductor region 3, a first P-type semiconductor region 4, a source region 6, a second P-type semiconductor region 8, a third P-type semiconductor region 9, and a fourth P-type semiconductor region 5. This embodiment is a variant of the implementations in the foregoing embodiment. The following describes only differences between this embodiment and the foregoing embodiment, and the same parts are not described herein again.

Refer to FIG. 32 and FIG. 33. In a part of the trench structure 7 of two adjacent trench structures 7, the first trenches 71 arranged in a first direction x are through. To be specific, a plurality of first trenches 71 may include a first gate trench and a second gate trench that communicate with each other in the first direction x. The first gate trench and the second gate trench may be considered to be respectively located in two adjacent trench structures. For example, a first edge trench (which may be considered as a first gate trench) in a left-side trench structure 7 and a first edge trench (which may be considered as a second gate trench) in a right-side trench structure 7 are arranged in the first direction x, and the two first edge trenches communicate with each other. A second edge trench (which may be considered as a first gate trench) in the left-side trench structure 7 and a second edge trench (which may be considered as a second gate trench) in the right-side trench structure 7 are arranged in the first direction x, and the two second edge trenches communicate with each other. Refer to FIG. 33. A first trench 71 in the middle of the left-side trench structure 7 and a first trench 71 in the middle of the right-side trench structure 7 may also communicate with each other.

Correspondingly, a contact hole 121 may include a plurality of contact sub-holes that are disposed at intervals, and at least one first trench that is through is disposed between two adjacent contact sub-holes in a same contact hole 121. FIG. 33 shows two contact sub-holes. A quantity of the contact sub-holes that contact hole 121 is divided into is not limited in this application. For example, there may be two, three, four, or more contact sub-holes. In addition, a quantity of first trenches 71 that are through and that are disposed between two adjacent contact sub-holes in a same contact hole 121 is not limited in this application. For example, there may be one, two, three, four, or more first trenches. In this way, design freedom of the contact hole 121 can be improved, and through-current uniformity of a SiC MOSFET device can be improved.

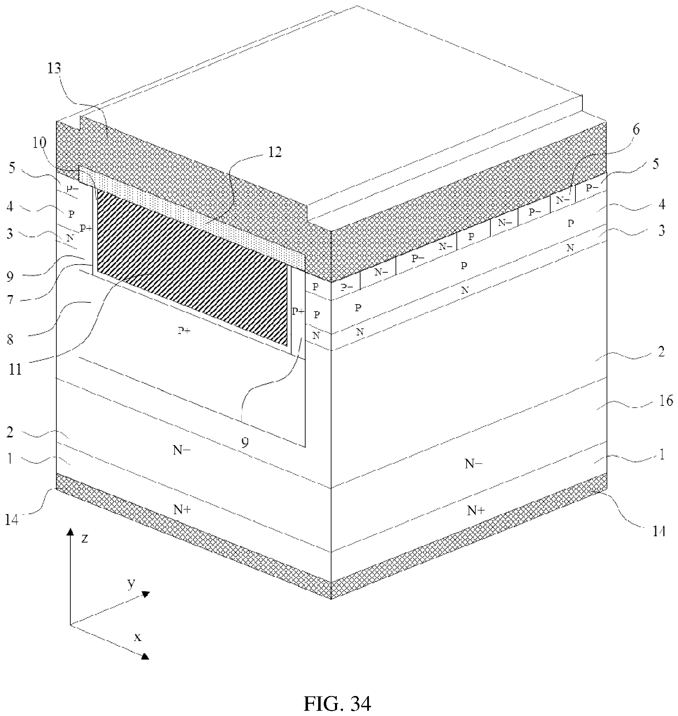

FIG. 34 shows a schematic diagram of a three-dimensional structure of a semiconductor device according to still another embodiment of this application.

Refer to FIG. 34. In still some other embodiments provided in this application, the semiconductor device may specifically include an N-type semiconductor substrate 1, an epitaxial layer, a trench structure 7, a gate 11, an interlayer dielectric layer 12, a source 13, and a drain 14. In addition, the epitaxial layer may include a third N-type semiconductor region 16, a first N-type semiconductor region 2, a second N-type semiconductor region 3, a first P-type semiconductor region 4, a source region 6, a second P-type semiconductor region 8, a third P-type semiconductor region 9, and a fourth P-type semiconductor region 5. This embodiment is a variant of the implementations in the foregoing embodiment. The following describes only differences between this embodiment and the foregoing embodiment, and the same parts are not described herein again.

Refer to FIG. 34. The third N-type semiconductor region 16 may be disposed between the first N-type semiconductor region 2 and the semiconductor substrate 1. Because the third N-type semiconductor region 16 is disposed, a thickness of the second P-type semiconductor region 8 at the epitaxial layer 100 in the third direction z may be set to be thicker. For example, the thickness of the second P-type semiconductor region 8 in the third direction z may be set to be greater than 1 µm.

Refer to FIG. 34. In this embodiment, the third N-type semiconductor region 16 may be SiC doped with an N-type impurity. The N-type impurity is, for example, nitrogen (N), phosphorus (P), or arsenic (As). For example, a doping concentration of the third N-type semiconductor region 16 may be less than a doping concentration of the first N-type semiconductor region 2.

For example, the structure shown in FIG. 34 is manufactured. For a flowchart of a corresponding manufacturing method, refer to FIG. 13. For steps S10 to S80, refer to the description of the foregoing manufacturing method.

In this embodiment, step S10 of epitaxially growing the epitaxial layer on the N-type semiconductor substrate may be specifically implemented in the following manner.

For example, refer to FIG. 34. A SiC material doped with the N-type impurity is epitaxially grown on the N-type SiC semiconductor substrate 1 by using an epitaxial growth process, to form the third N-type semiconductor region 16. Then, the SiC material doped with the N-type impurity is epitaxially grown on the third N-type semiconductor region 16 by using the epitaxial growth process, to form the epitaxial layer 100 that reaches a first specified thickness DS 1.

An embodiment of this application further provides a power conversion circuit. The power conversion circuit may be an alternating current-direct current conversion circuit and/or a direct current-direct current conversion circuit. The power conversion circuit may include a circuit board and one or more semiconductor devices, and the semiconductor device is connected to the circuit board. Because performance of the foregoing semiconductor device is good, performance of a power conversion circuit including the foregoing semiconductor device is also good. In addition, a problem-resolving principle of the power conversion circuit is similar to a problem-resolving principle of the foregoing semiconductor device. Therefore, for technical effects of the power conversion circuit, refer to technical effects of the foregoing semiconductor device. Repeated content is not described again.

An embodiment of this application further provides a vehicle, and the vehicle includes a power conversion circuit provided in an embodiment of this application. Because performance of the foregoing power conversion circuit is good, circuit performance of a vehicle including the foregoing power conversion circuit is also good. In addition, a problem-resolving principle of the vehicle is similar to a problem-resolving principle of the foregoing power conversion circuit. Therefore, for technical effects of the vehicle, refer to technical effects of the foregoing power conversion circuit. Repeated content is not described again.

Apparently, a person skilled in the art can make various modifications and variations to this application without departing from the scope of this application. This application is intended to cover these modifications and variations of this application provided that they fall within the scope of the claims of this application and an equivalent technology thereof.

## Claims

1. A semiconductor device, comprising:
an N-type semiconductor substrate;
an epitaxial layer, disposed on the semiconductor substrate;
a trench structure, disposed at the epitaxial layer, wherein the trench structure comprises a plurality of first trenches and one second trench, all of the plurality of first trenches extend in a first direction parallel to a plane on which the semiconductor substrate is located, and are arranged at intervals in a second direction parallel to the plane on which the semiconductor substrate is located, the second trench extends in the second direction, and the second trench and each of the plurality of first trenches are disposed in a cross manner and communicate with each other;
a gate, wherein the gate is filled and disposed in the trench structure, and is spaced apart by a gate dielectric layer;
an interlayer dielectric layer, wherein the interlayer dielectric layer is disposed on the gate and covers the gate, the interlayer dielectric layer has a contact hole that extends in the second direction, the contact hole exposes a partial region of the epitaxial layer, a projection of the contact hole in a third direction perpendicular to the plane on which the semiconductor substrate is located does not overlap the gate, and the first direction, the second direction, and the third direction are set in a cross manner;
a source, wherein the source is disposed at the interlayer dielectric layer, and the source is in contact, through the contact hole, with the epitaxial layer exposed by the contact hole; and
a drain, wherein the drain is disposed on a side that is of the semiconductor substrate and that is away from the epitaxial layer.

2. The semiconductor device according to claim 1, wherein the plurality of first trenches comprise a first gate trench and a second gate trench that communicate with each other in the first direction, and the first gate trench and the second gate trench are respectively located in two adjacent trench structures; and
the contact hole comprises a plurality of contact sub-holes that are disposed at intervals, and at least one first trench that is through is disposed between two adjacent contact sub-holes in a same contact hole.

3. The semiconductor device according to claim 1 or 2, wherein the epitaxial layer comprises: a first N-type semiconductor region, a second N-type semiconductor region, a first P-type semiconductor region, and a source region that are sequentially disposed on the semiconductor substrate;
in the third direction perpendicular to the plane on which the semiconductor substrate is located, the trench structure extends to the first N-type semiconductor region; and
the contact hole exposes a partial region of the source region.

4. The semiconductor device according to claim 3, wherein the epitaxial layer further comprises:
a second P-type semiconductor region, wherein the second P-type semiconductor region is disposed in the first N-type semiconductor region and is located below the trench structure, and the second P-type semiconductor region is connected to the source.

5. The semiconductor device according to claim 4, wherein the epitaxial layer further comprises:
a third P-type semiconductor region, wherein the third P-type semiconductor region is disposed on at least one side wall of the trench structure, and the third P-type semiconductor region is in contact with the second P-type semiconductor region; and
a fourth P-type semiconductor region, wherein the fourth P-type semiconductor layer and the source region are disposed at a same layer, and the fourth P-type semiconductor region and the third P-type semiconductor region are disposed in a one-to-one correspondence and are in contact with each other.

6. The semiconductor device according to claim 5, wherein each of the plurality of first trenches has a first side wall and a second side wall that are disposed opposite to each other in the first direction; and
the third P-type semiconductor region is disposed on a first side wall and/or a second side wall of at least one of the plurality of first trenches, and the fourth P-type semiconductor region is in contact with the source through the contact hole.

7. The semiconductor device according to claim 6, wherein the third P-type semiconductor region is disposed only on the first side wall or the second side wall of the at least one of the plurality of first trenches;
the epitaxial layer further comprises a fifth P-type semiconductor region, wherein the fifth P-type semiconductor layer and the source region are disposed at a same layer, the fifth P-type semiconductor layer is disposed on sides that are of side walls of the plurality of first trenches and on which the third P-type semiconductor region is not disposed, and doping concentrations of the fifth P-type semiconductor region and the fourth P-type semiconductor region are the same;
the fifth P-type semiconductor region is in contact with a side wall of a corresponding first trench in the plurality of first trenches, and the fifth P-type semiconductor region is in contact with the corresponding source through the contact hole; and
the fifth P-type semiconductor region and the source region are alternately disposed on a side that is of the first trench and that faces the side wall.

8. The semiconductor device according to claim 6 or 7, wherein a width of the fourth P-type semiconductor region is equal to a width of the first trench, and a trench spacing between two adjacent first trenches is equal to a width of the source region.

9. The semiconductor device according to claim 5, wherein at least one end part of the second trench extends out to a first trench located at an edge in the plurality of first trenches;
the second trench has a third side wall and a fourth side wall that are disposed opposite to each other in the second direction; and
the third P-type semiconductor region is disposed on the third side wall and/or the fourth side wall of the second trench.

10. The semiconductor device according to claim 9, wherein the epitaxial layer further comprises the fifth P-type semiconductor region that is at a same layer as the source region and that is alternately disposed with the corresponding source region, and the doping concentrations of the fifth P-type semiconductor region and the fourth P-type semiconductor region are the same; and
the fifth P-type semiconductor region is in contact with a side wall of at least one of the plurality of first trenches, and the fifth P-type semiconductor region is in contact with the corresponding source through the contact hole.

11. The semiconductor device according to any one of claims 5 to 10, wherein doping concentrations of the second P-type semiconductor region, the third P-type semiconductor region, and the fourth P-type semiconductor region are all greater than a doping concentration of the first P-type semiconductor region.

12. The semiconductor device according to any one of claims 5 to 11, wherein a projection of the second P-type semiconductor region in the third direction covers the trench structure and the third P-type semiconductor region.

13. The semiconductor device according to any one of claims 4 to 12, wherein the epitaxial layer further comprises a third N-type semiconductor region disposed between the first N-type semiconductor region and the semiconductor substrate, and a doping concentration of the third N-type semiconductor region is less than a doping concentration of the first N-type semiconductor region; and
a thickness of the second P-type semiconductor region is greater than 1 µm.

14. The semiconductor device according to any one of claims 3 to 13, wherein a doping concentration of the semiconductor substrate is greater than a doping concentration of the second N-type semiconductor region, and the doping concentration of the second N-type semiconductor region is greater than the doping concentration of the first N-type semiconductor region.

15. The semiconductor device according to any one of claims 1 to 14, wherein materials of the semiconductor substrate and the epitaxial layer are SiC.

16. A manufacturing method for a semiconductor device, comprising:
epitaxially growing an epitaxial layer on an N-type semiconductor substrate; etching at the epitaxial layer to form a trench structure, wherein the trench structure comprises a plurality of first trenches and one second trench, all of the plurality of first trenches extend in a first direction parallel to a plane on which the semiconductor substrate is located, and are arranged at intervals in a second direction parallel to the plane on which the semiconductor substrate is located, the second trench extends in the second direction, and the second trench and each of the plurality of first trenches are disposed in a cross manner and communicate with each other;
sequentially forming a gate dielectric layer and a gate in the trench structure;
forming, on the gate, an interlayer dielectric layer that covers the epitaxial layer;
etching at the interlayer dielectric layer to form a contact hole extending in the second direction, wherein the contact hole exposes a partial region of the epitaxial layer, a projection of the contact hole in a third direction perpendicular to the plane on which the semiconductor substrate is located does not overlap the gate, and the first direction, the second direction, and the third direction are set in a cross manner;
forming a source at the interlayer dielectric layer, wherein the source is in contact, through the contact hole, with the epitaxial layer exposed by the contact hole; and
forming a drain on a side that is of the semiconductor substrate and that is away from the epitaxial layer.

17. The manufacturing method according to claim 16, wherein after the epitaxially growing an epitaxial layer on an N-type semiconductor substrate, the manufacturing method further comprises:
performing ion implantation in a partial region of the epitaxial layer by using an ion implantation process, to sequentially form a second N-type semiconductor region, a first P-type semiconductor region, and a source region, wherein a region that is of the epitaxial layer and in which ion implantation is not performed forms a first N-type semiconductor region, wherein
the contact hole exposes a partial region of the source region.

18. The manufacturing method according to claim 17, wherein the epitaxially growing an epitaxial layer on an N-type semiconductor substrate comprises:
epitaxially growing, on the N-type semiconductor substrate, an epitaxial layer that reaches a first specified thickness;
performing ion implantation at the epitaxial layer by using the ion implantation process, to form a second P-type semiconductor region; and
continuing epitaxial growth at the epitaxial layer at which the second P-type semiconductor region is formed, until an epitaxial layer that reaches a second specified thickness is formed.

19. The manufacturing method according to claim 18, further comprising:
before the sequentially forming a gate dielectric layer and a gate in the trench structure, forming, by using a tilted ion implantation process on at least one side wall of the trench structure, a third P-type semiconductor region in contact with the second P-type semiconductor region; and
forming, at the epitaxial layer by using the ion implantation process, a fourth P-type semiconductor region disposed at a same layer as the source region.

20. A power conversion circuit, comprising a circuit board and one or more semiconductor devices according to any one of claims 1 to 15, wherein the semiconductor device is connected to the circuit board.

21. A vehicle, comprising the power conversion circuit according to claim 20, wherein the power conversion circuit is configured to convert an alternating current and/or a direct current and output a direct current.
